# EUROPEAN PATENT APPLICATION

(11) **EP 4 376 105 A1**
(43) Date of publication of application: **29.05.2024**
(21) Application number: 22845863.4
(22) Date of filing: 15.07.2022
(51) Int. Cl.: H01L 33/22, G09F 9/00, G09F 9/33, H01L 33/32, H01L 33/50

(54) **LIGHT EMITTING DEVICE, DISPLAY DEVICE, ELECTRONIC INSTRUMENT, AND METHOD AND APPARATUS FOR MANUFACTURING LIGHT EMITTING DEVICE**

(30) Priority: 21.07.2021 JP 2021120982
(71) Applicant: Kyocera Corporation, Kyoto-shi Kyoto 612-8501 (JP)
(72) Inventor: KAMIKAWA, Takeshi, Kyoto-shi, Kyoto 612-8501 (JP); TANIGUCHI, Yuki, Kyoto-shi, Kyoto 612-8501 (JP); MURAKAWA, Kentaro, Kyoto-shi, Kyoto 612-8501 (JP); KAWAGUCHI, Yoshinobu, Kyoto-shi, Kyoto 612-8501 (JP); MASAKI, Katsuaki, Kyoto-shi, Kyoto 612-8501 (JP); HAYASHI, Yuichiro, Kyoto-shi, Kyoto 612-8501 (JP)
(74) Representative: Viering, Jentschura & Partner mbB Patent- und Rechtsanwälte
(86) International application number: PCT/JP2022/027815
(87) International publication number: WO 2023/002929

(57) **Abstract**

Provided are a semiconductor substrate including a main substrate, a mask located above the main substrate and including a mask portion and an opening portion, and a base semiconductor part located above the mask and a compound semiconductor part located above the semiconductor substrate and including a first light emitting portion. The semiconductor substrate includes a first hole passing through the main substrate in a thickness direction and overlapping the first light emitting portion below the first light emitting portion.

## Description

### TECHNICAL FIELD

The present disclosure relates to a light emitting device and the like.

### BACKGROUND OF INVENTION

For example, Patent Document 1 discloses a technique of forming a plurality of light emitting diodes (LEDs) on a substrate.

### CITATION LIST

### PATENT LITERATURE

Patent Document 1: US 10,381,507 B2

### SUMMARY

A light emitting device according to the present disclosure includes: a semiconductor substrate including a main substrate, a mask located above the main substrate and including a mask portion and an opening portion, and a base semiconductor part located above the mask; and a compound semiconductor part located above the semiconductor substrate and including a first light emitting portion. The semiconductor substrate includes a first hole passing through the main substrate in a thickness direction and overlapping the first light emitting portion below the first light emitting portion.

### BRIEF DESCRIPTION OF THE DRAWINGS

FIG. 1 is a cross-sectional view illustrating a configuration of a light emitting device according to the present embodiment.
FIG. 2 is a flowchart illustrating an example of a method for manufacturing the light emitting device according to the present embodiment.
FIG. 3 is a block diagram illustrating an example of a manufacturing apparatus for the light emitting device according to the present embodiment.
FIG. 4 is a cross-sectional view illustrating a configuration of a display device according to the present embodiment.
FIG. 5 is a cross-sectional view of a light emitting device according to Example 1, taken along an X-direction.
FIG. 6 is a cross-sectional view of the light emitting device according to Example 1 taken along a Y-direction.
FIG. 7 is a plan view of the light emitting device according to Example 1.
FIG. 8 is a plan view illustrating another configuration of the light emitting device according to Example 1.
FIG. 9 is a plan view illustrating another configuration of the light emitting device according to Example 1.
FIG. 10 is a flowchart illustrating an example of a method for manufacturing the light emitting device according to Example 1.
FIG. 11 is a cross-sectional view illustrating an example of the method for manufacturing the light emitting device according to Example 1.
FIG. 12 is a flowchart illustrating another example of the method for manufacturing the light emitting device according to Example 1.
FIG. 13 is a cross-sectional view illustrating the method for manufacturing the light emitting device in FIG. 12.
FIG. 14 is a cross-sectional view illustrating an example of lateral growth of a base semiconductor part.
FIG. 15 is a schematic cross-sectional view illustrating configurations of the base semiconductor part and a compound semiconductor part.
FIG. 16 is a cross-sectional view illustrating a configuration of a display device according to Example 1.
FIG. 17 is a cross-sectional view illustrating a configuration of the display device according to Example 1.
FIG. 18 is a block diagram illustrating a configuration of the display device according to Example 1.
FIG. 19 is a cross-sectional view illustrating an example of a configuration a drive substrate.
FIG. 20 is a cross-sectional view of a light emitting device according to Example 2 taken along the X-direction.
FIG. 21 is a cross-sectional view of the light emitting device according to Example 2, taken along a Y-direction.
FIG. 22 is a plan view of the light emitting device according to Example 2.
FIG. 23 is a cross-sectional view illustrating another configuration of the light emitting device according to Example 2.
FIG. 24 is a cross-sectional view illustrating another configuration of the light emitting device according to Example 2.
FIG. 25 is a cross-sectional view illustrating another configuration of the light emitting device according to Example 2.
FIG. 26 is a cross-sectional view illustrating another configuration of the light emitting device according to Example 2.
FIG. 27 is a cross-sectional view illustrating another configuration of the light emitting device according to Example 2.
FIG. 28 is a cross-sectional view illustrating another configuration of the light emitting device according to Example 2.
FIG. 29 is a cross-sectional view illustrating another configuration of the light emitting device according to Example 2.
FIG. 30 is a cross-sectional view illustrating another configuration of the light emitting device according to Example 2.
FIG. 31 is a cross-sectional view of a light emitting device according to Example 3 taken along the X-direction.
FIG. 32 is a cross-sectional view of the light emitting device according to Example 3, taken along a Y-direction.
FIG. 33 is a plan view of the light emitting device according to Example 3.
FIG. 34 is a cross-sectional view illustrating another configuration of the light emitting device according to Example 3.
FIG. 35 is a cross-sectional view illustrating another configuration of the light emitting device according to Example 3.
FIG. 36 is a cross-sectional view illustrating another configuration of the light emitting device according to Example 3.
FIG. 37 is a plan view illustrating another configuration of the light emitting device according to Example 3.
FIG. 38 is a cross-sectional view illustrating another configuration of the light emitting device according to Example 4.
FIG. 39 is a cross-sectional view illustrating another configuration of the light emitting device according to Example 4.
FIG. 40 is a flowchart illustrating a method for manufacturing a light emitting device according to Example 5.
FIG. 41 is a cross-sectional view illustrating a configuration of the light emitting device according to Example 5.
FIG. 42 is a flowchart illustrating another method for manufacturing the light emitting device according to Example 5.
FIG. 43 is a cross-sectional view illustrating another configuration of the light emitting device according to Example 5.
FIG. 44 is a cross-sectional view illustrating another configuration of the light emitting device according to Example 5.
FIG. 45 is a schematic plan view illustrating a display device of Example 7.
FIG. 46 is a schematic diagram illustrating a configuration of an electronic device according to Example 8.

### DESCRIPTION OF EMBODIMENTS

### Light Emitting Device

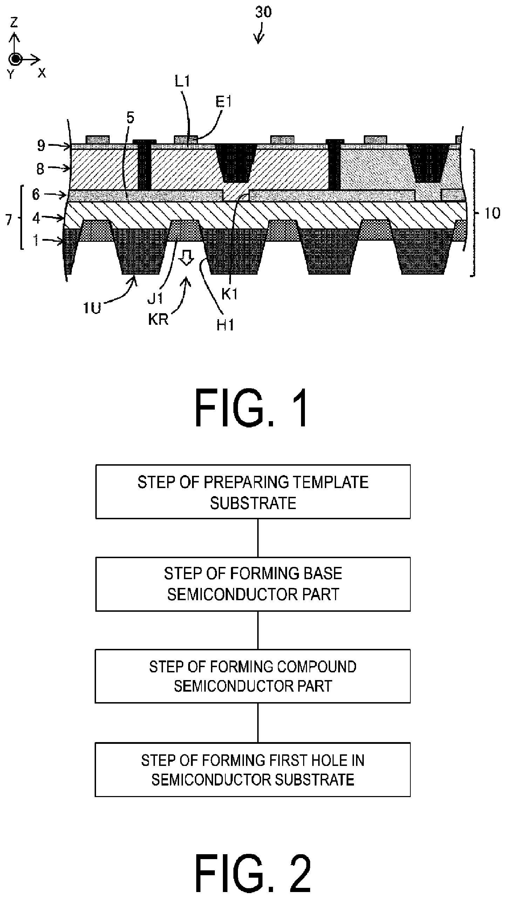

FIG. 1 is a cross-sectional view illustrating a configuration of a light emitting device according to the present embodiment. As illustrated in FIG. 1, a light emitting device 30 according to the present embodiment includes: a semiconductor substrate 10 including a main substrate 1, a mask 6 located above the main substrate 1 and including a mask portion 5 and an opening portion K1, and a base semiconductor part 8 located above the mask 6; and a compound semiconductor part 9 located above the semiconductor substrate 10 and including a first light emitting portion L1. The semiconductor substrate 10 includes the main substrate 1 (for example, a free-supporting substrate having bulk crystal) and a semiconductor (for example, a semiconductor layer), and the main substrate 1 may be a semiconductor or may be a non-semiconductor. In the light emitting device 30, the direction from the main substrate 1 (for example, a free-supporting substrate having bulk crystal) to the base semiconductor part 8 is defined as the upward direction (and thus may be different from the upward direction along the vertical direction or the upward direction in drawings). The mask 6 may be a mask pattern including the mask portion 5 and the opening portion K1. The opening portion K1 is a region without the mask portion 5, and the opening portion K1 is not necessarily be surrounded by the mask portion 5.

The semiconductor substrate 10 includes a first hole H1 passing through the main substrate 1 in the thickness direction and overlapping the first light emitting portion L1 below the first light emitting portion L1. In other words, the first hole H1 overlaps the first light emitting portion L1 in plan view (viewed in the normal direction of the main substrate 1). Two components overlapping each other in plan view means that at least part of one component overlaps the other component when viewed (including when perspectively viewed) in the normal direction of the main substrate 1. The two components may separately overlap each other (for example, in the upward and downward direction). A first electrode E1 can be provided above the compound semiconductor part 9. The first hole H1 has an opening KR serving as a light emission surface on a back surface 1U (lower surface) of the main substrate 1.

The light emitting device 30 allows, even when the main substrate 1 and the base semiconductor part 8 have different lattice constants, threading dislocations (defects) in the base semiconductor part 8 and the compound semiconductor part 9 to decrease on the mask portion 5, thus enhancing the light emission efficiency of the first light emitting portion L1 included in the compound semiconductor part 9 (for example, the ratio of the amount of light to the amount of charge injected from the first electrode E1). The threading dislocation, which is a dislocation (defect) that extends from the base semiconductor part 8 to the compound semiconductor part 9, suppresses charge transfer and causes heat generation.

The light emitting device 30 includes the main substrate 1 and has rigidity. Providing a first wavelength conversion layer J1 in the first hole H1 allows light having a longer wavelength than light generated in the first light emitting portion L1 (for example, a visible light range) to be emitted from the opening KR.

The base semiconductor part 8 and the compound semiconductor part 9 includes, for example, a nitride semiconductor. The nitride semiconductor may be expressed, for example, by AlxGayInzN (0 ≤ x ≤ 1; 0 ≤ y ≤ 1; 0 ≤ z ≤ 1; x + y + z = 1). Specific examples of the nitride semiconductor may include a GaN-based semiconductor, aluminum nitride (AlN), indium aluminum nitride (InAlN), and indium nitride (InN). The GaN-based semiconductor is a semiconductor containing gallium atoms (Ga) and nitrogen atoms (N). Typical examples of the GaN-based semiconductor may include GaN, AlGaN, AlGaInN, and InGaN. The base semiconductor part 8 may be of a doped type (for example, n-type including a donor) or a non-doped type.

The base semiconductor part 8 including a nitride semiconductor may be formed by not only an epitaxial lateral overgrowth (ELO) method but also another technique by which low defects can be achieved. In the ELO method, for example, using a heterogeneous substrate having a lattice constant different from that of the base semiconductor part 8 as the main substrate 1, using the nitride semiconductor for an underlying portion 4, using an inorganic compound film for the mask portion 5, and exposing the underlying portion 4 to the opening portion K1 allow the base semiconductor part 8 to be grown in the lateral direction (Y-direction) on the mask portion 5.

Hereinafter, the main substrate 1 and the underlying portion 4 may be collectively referred to as an underlying substrate, and the main substrate 1, the underlying portion 4, and the mask 6 may be collectively referred to as a template substrate 7. A base semiconductor part formed by the ELO method may be referred to as an ELO semiconductor layer.

When the base semiconductor part 8 is formed by using the ELO method, the template substrate 7 including the main substrate 1 and the mask 6 on the main substrate 1 may be used. The template substrate 7 may include a growth suppression region (for example, a region in which crystal growth in the Z-direction is suppressed) corresponding to the mask portion 5 and a seed region corresponding to the opening portion K1. For example, the growth suppression region and the seed region may also be formed on the main substrate 1 to form the base semiconductor part 8 on the growth suppression region and the seed region by using the ELO method.

### Manufacture of Light Emitting Device

FIG. 2 is a flowchart illustrating an example of a method for manufacturing the light emitting device according to the present embodiment. In the method for manufacturing the light emitting device in FIG. 2, after a step of preparing the template substrate (substrate for ELO growth) 7, a step of forming the base semiconductor part 8 by using the ELO method is performed to obtain the semiconductor substrate 10. Next, a step of forming the compound semiconductor part 9 is performed, and then a step of etching the main substrate 1 from the back surface 1U thereof to form the first hole H1 is performed.

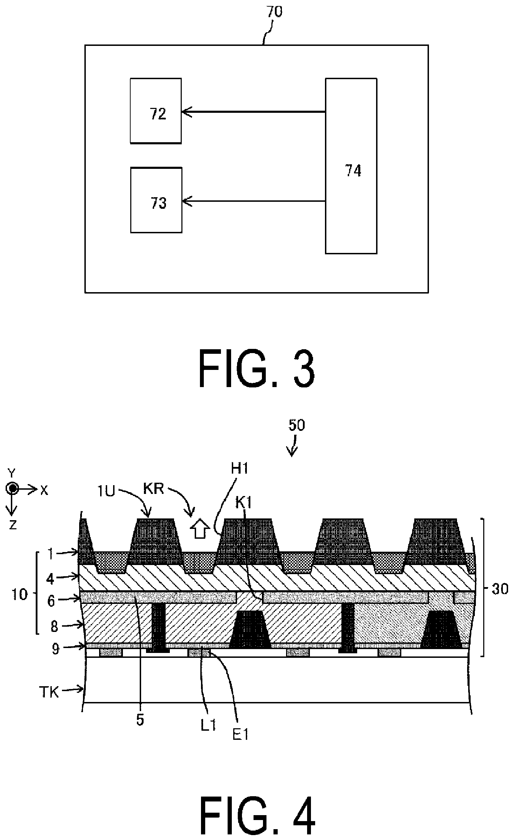

FIG. 3 is a block diagram illustrating an example of a manufacturing apparatus for manufacturing the light emitting device according to the present embodiment. A manufacturing apparatus 70 for a light emitting device in FIG. 3 includes a semiconductor former 72 that forms the base semiconductor part 8 and the compound semiconductor part 9 on the template substrate 7, a substrate processing unit 73 that etches the main substrate 1 from a back surface 1U thereof, and a controller 74 that controls the semiconductor former 72 and a substrate processing unit 73.

The semiconductor former 72 may include a metal organic chemical vapor deposition (MOCVD) apparatus, and the controller 74 may include a processor and a memory. The controller 74 may control the semiconductor former 72 and the substrate processing unit 73 by executing a program stored, for example, in a built-in memory or a communicable communication apparatus or on an accessible network. The program and a recording medium or the like in which the program is stored are also included in the present embodiment.

### Display Device

FIG. 4 is a cross-sectional view illustrating a configuration of a display device according to the present embodiment. As illustrated in FIG. 4, a display device 50 includes the light emitting device 30 and a drive substrate TK that is disposed on the side of the light emitting device 30 opposite to the main substrate 1 and is electrically connected to the first electrode E1. The drive substrate TK includes a pixel circuit that controls the intensity of light emitted from the first light emitting portion L1 (as will be described below). The drive substrate TK may have a configuration in which the pixel circuit including a plurality of transistors is formed on a glass substrate or a resin substrate, or may have a configuration in which the pixel circuit including a plurality of transistors is formed on a silicon substrate. The pixel circuit may include a complementary metal oxide semiconductor (CMOS) circuit.

### Example 1

### Overall Configuration

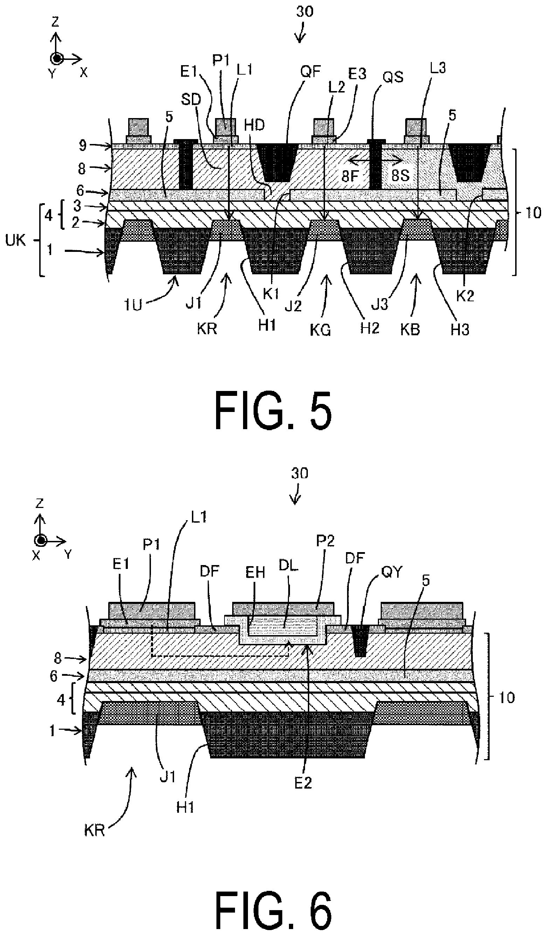

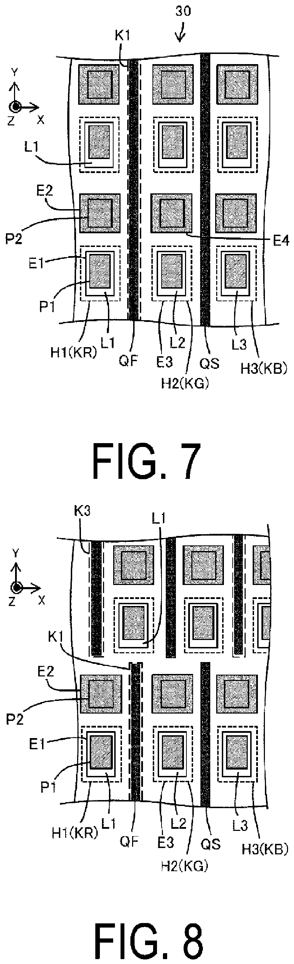

FIG. 5 is a cross-sectional view of a light emitting device according to Example 1 taken along the X-direction. FIG. 6 is a cross-sectional view of the light emitting device according to Example 1 taken along the Y-direction. FIG. 7 is a plan view of the light emitting device according to Example 1. As illustrated in FIGs. 5, 6, and 7, the light emitting device 30 according to Example 1 includes the semiconductor substrate 10, the compound semiconductor part 9 located on the semiconductor substrate 10, first and second electrodes E1 and E2. The semiconductor substrate 10 includes the main substrate 1, the underlying portion 4 located on the main substrate 1, the mask 6 located on the underlying portion 4 and including the mask portion 5 and opening portions K1 and K2, and the base semiconductor part 8 located on the mask 6. The compound semiconductor part 9 includes the first light emitting portion L1. The first electrode E1 is located above the compound semiconductor part 9, and the second electrode E2 is located above the base semiconductor part 8. The base semiconductor part 8 and the compound semiconductor part 9 may include a nitride semiconductor (for example, GaN-based semiconductor). The X-direction is the <11-20> direction (a-axis direction) of the base semiconductor part 8, the Y-direction is the <1-100> direction (m-axis direction) of the base semiconductor part 8, and the Z-direction is the <0001> direction (c-axis direction) of the base semiconductor part 8. In other words, the X-direction is the <11-20> direction in the crystal structure of a nitride semiconductor (a GaN-based semiconductor for example), the Y-direction is the <1-100> direction in the crystal structure of a nitride semiconductor (for example, a GaN-based semiconductor), and the Z-direction is the <0001> direction in the crystal structure of a nitride semiconductor (for example, a GaN-based semiconductor). The configuration below the mask 6 (for example, the main substrate 1 and the underlying portion 4) may be referred to as an underlying substrate UK. The underlying substrate and the mask 6 may be collectively referred to as the template substrate 7. The underlying portion 4 may be a base layer. The mask 6 may be a mask layer. The base semiconductor part 8 may be a base semiconductor layer. The compound semiconductor part 9 may be a compound semiconductor layer or a device layer.

The main substrate 1 is a heterogeneous substrate having a lattice constant different from that of the base semiconductor part 8. The main substrate 1 may be a light-shielding substrate an example of which includes a silicon substrate. The main substrate 1 includes the first hole H1 passing through between the lower surface and the upper surface and overlapping the first light emitting portion L1 in plan view. The first hole H1 may have a tapered shape tapered toward the base semiconductor part 8 side.

In the first hole H1, the first wavelength conversion layer J1 that emits light having a wavelength longer than wavelength of the received light is provided. The first wavelength conversion layer J1 converts light (for example, ultraviolet light) received from the first light emitting portion L1 into visible light by, for example, a photoluminescence effect. The visible light thus obtained by the conversion is emitted to the outside through the first hole H1. The first wavelength conversion layer J1 may include at least one of a fluorescent material or a phosphorescent material. The first hole H1 has the opening KR serving as a light emission plane for the visible light, in the back surface (lower surface) 1U of the main substrate 1. The shape of the opening KR is a rectangle (see FIG. 7), a rhombus, a circle, an ellipse, or the like but is not limited to these. In Example 1, the underlying portion 4 includes at least part of the bottom portion of the first hole H1. As illustrated in FIG. 5, the entire bottom portion of the first hole H1 may be located in the underlying portion 4.

The base semiconductor part 8 includes a first portion HD located on the opening portion K1 and a second portion SD (low defect portion) located on the mask portion 5 and having a threading dislocation density lower than that of the first portion HD. The second portion SD overlaps the first light emitting portion L1 in plan view. The threading dislocation density of the second portion SD may be, for example, 5 × 10⁶/cm² or less. With this configuration, the light emission efficiency of the first light emitting portion L1 can be improved. The threading dislocation extends in the thickness direction of the base semiconductor part 8 and reaches the surface layer thereof.

In Example 1, the first and the second electrodes E1 and E2 are aligned in the Y-direction. The first electrode E1 is, for example, an anode (p-electrode), and the second electrode E2 is, for example, a cathode (n-electrode). The first electrode E1 overlaps the first light emitting portion L1 in plan view. With this configuration, a short current path between the first electrode E1 and the first light emitting portion L1 can be achieved. The first and the second electrodes E1 and E2 have light reflectivity. With this configuration, light traveling from the first light emitting portion L1 toward the first electrode E1 is reflected toward the main substrate 1 side, whereby light utilization efficiency is improved.

The light emitting device 30 includes a first pad P1 connected to the first electrode E1 and a second pad P2 connected to the second electrode E2. At least part of the second pad P2 does not overlap the first hole H1 in plan view. This configuration reduces an impact on the base semiconductor part 8 and the compound semiconductor part 9 as a result of the pressing toward the second pad P2 (generation of defects such as a crack in the base semiconductor part 8 for example) when the drive substrate TK and the light emitting device 30 are bonded to each other. A position of an upper surface of the first pad P1 matches a position of an upper surface of the second pad P2, allowing for easy mounting on the drive substrate TK (see FIG. 4). A configuration in which the first and the second electrodes E1 and E2 do not contact the base semiconductor part 8 and an insulating film DF is located between the first and the second electrodes E1 and E2 and the base semiconductor part 8 can be employed. The insulating film DF may be transparent.

In FIG. 6, the second electrode E2 comes into contact with the base semiconductor part 8. When the second electrode E2 is the cathode, the base semiconductor part 8 may be configured by an n-type semiconductor. The second electrode E2 may have a recessed portion EH, and an insulating layer DL may be provided in the recessed portion EH. The insulating layer DL provided in the recessed portion EH allows the upper surface of the second pad P2 to be planarized. A light-shielding layer QY may be provided in a gap between two sets, adjacent to each other in the Y-direction, each including the first electrode E1 and the second electrode E2. Part of the light-shielding layer QY may be located in the base semiconductor part 8. The light-shielding layer QY may have a light absorbing property or may have an index of refraction lower than that of the base semiconductor part 8.

The compound semiconductor part 9 includes a second light emitting portion L2 and a third light emitting portion L3. The main substrate 1 includes a second hole H2 that is a through hole formed in the thickness direction (Z-direction) and overlaps the second light emitting portion L2 in plan view, and a third hole H3 that is a through hole formed in the thickness direction and overlaps the third light emitting portion L3 in plan view.

The first to the third light emitting portions L1 to L3 are aligned in the X-direction, and the first to the third holes H1 to H3 are also aligned in the X-direction. The emission peak wavelength of each of the first to the third light emitting portions L1 to L3 may be in a wavelength range from 430 to 640 [nm] (visible light range). The light emitting device 30 includes a third electrode E3 and a fourth electrode E4, the third electrode E3 overlaps the second light emitting portion L2 in plan view, and the first and the third electrodes E1 and E3 are aligned in the X-direction. The third and the fourth electrodes E3 and E4 are aligned in the Y-direction, and the second and the fourth electrodes E2 and E4 are aligned in the X-direction.

The light emitting device 30 includes a first partition wall portion QF located in a gap between the first and the second light emitting portions L1 and L2 in plan view. The first partition wall portion QF has light shielding property (for example, a property of absorbing light having emission wavelengths of the first and the second light emitting portions L1 and L2) and overlaps the opening portion K1 of the mask 6 in plan view. The first partition wall portion (light-shielding layer) QF may have an index of refraction lower than that of the base semiconductor part 8.

The light emitting device 30 includes a second partition wall portion QS located in a gap between the second and the third light emitting portions L2 and L3 in plan view. The second partition wall portion QS has a light shielding property (for example, a property of absorbing light having emission wavelengths of the second and the third light emitting portions L2 and L3) and overlaps the center of the mask portion 5 in plan view. The first and the second partition wall portions QF and QS have a shape having a longitudinal direction as the Y-direction. The second partition wall portion (light-shielding layer) QS may have an index of refraction lower than that of the base semiconductor part 8.

The base semiconductor part 8 includes a first region 8F and a second region 8S separated from each other. The first region 8F overlaps the opening portion K1 in plan view, and the second region 8S overlaps the opening portion K2 in plan view. Each of the first and the second regions 8F and 8S has an elongated shape, and the second partition wall portion QS is disposed between the first and the second regions 8F and 8S.

The first and the second partition wall portions QF and QS function to reduce, for example, a crosstalk phenomenon in which light generated in the light emitting portion L1 enters a hole (for example, the hole H2) other than the hole H1 or enters an active layer of another light emitting portion (for example, the light emitting portion L2). From this point of view, the first and the second partition wall portions QF and QS is any film having low light transmittance (may be not only a film having light absorptivity but also a film having light reflectivity) and specifically may be a metal film of Al, Ag, Cu, Cr, Au, or the like, a semiconductor film, a dielectric film, a resin film (for example, light absorptive black photoresist), or the like.

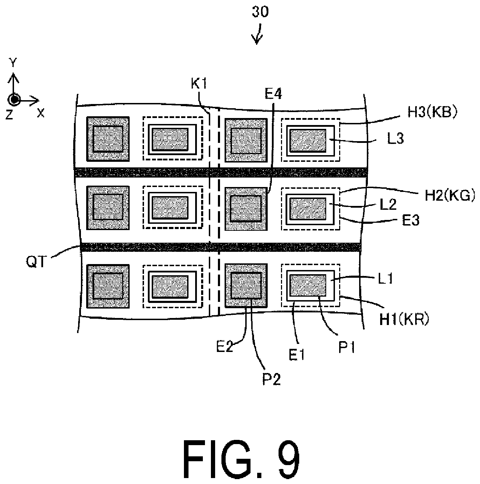

FIG. 8 is a plan view illustrating another configuration of the light emitting device according to Example 1. In FIG. 7, a plurality of the first light emitting portions L1 is linearly arranged in the Y-direction, but the configuration is not limited thereto. As illustrated in FIG. 8, the plurality of first light emitting portions L1 may be arranged in a staggered manner in the Y-direction. The plurality of first light emitting portions L1 may emit light of the same color. In FIG. 8, opening portions K1 and K3 are arranged in a staggered manner with respect to the Y-direction. FIG. 9 is a plan view illustrating another configuration of the light emitting device according to Example 1. In FIG. 7, the first to the third light emitting portions L1 to L3 are aligned in the X-direction (the <11-20> direction of the base semiconductor part 8), but the configuration is not limited thereto. As illustrated in FIG. 9, the first to the third light emitting portions L1 to L3 may be aligned in the Y-direction (the <1-100> direction of the base semiconductor part 8). A third partition wall portion (light-shielding layer) QT may be provided in a gap between the first light emitting portion L1 and the second light emitting portion L2 and a gap between the second light emitting portion L2 and the third light emitting portion L3 aligned in the Y-direction. The third partition wall portion QT may have a light absorbing property or may have an index of refraction lower than that of the base semiconductor part 8.

### Manufacturing Method

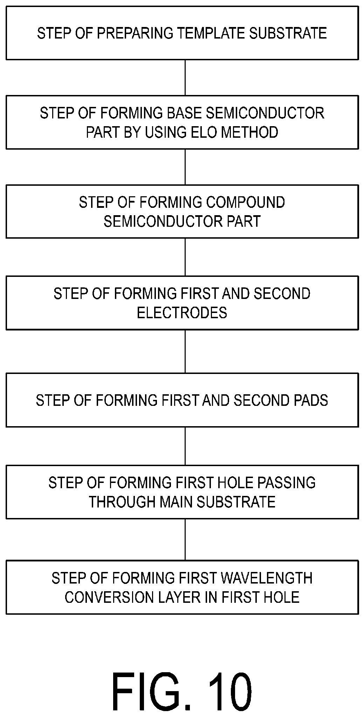

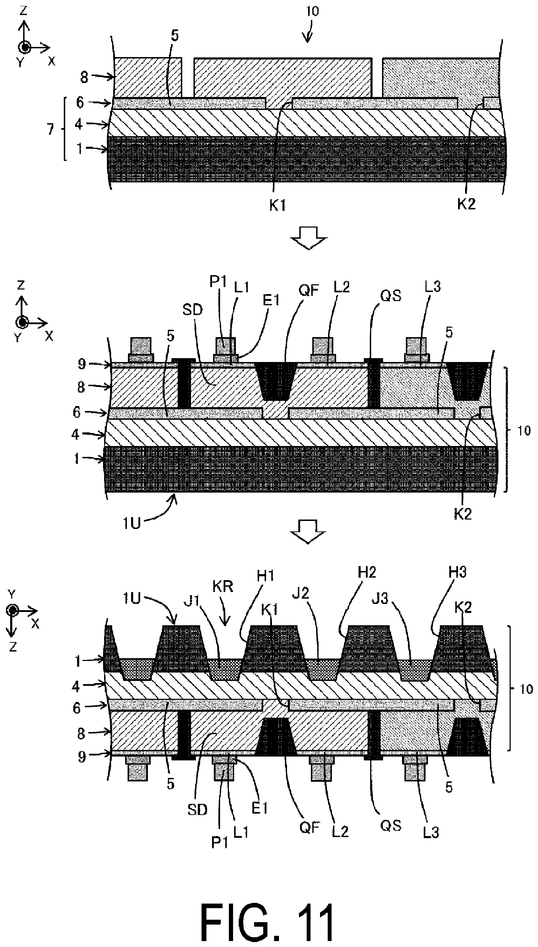

FIG. 10 is a flowchart illustrating an example of a method for manufacturing the light emitting device according to Example 1. FIG. 11 is a cross-sectional view illustrating an example of the method for manufacturing the light emitting device according to Example 1. In the method for manufacturing the light emitting device in FIG. 10 and FIG. 11, after a step of preparing the template substrate 7, a step of forming the base semiconductor part 8 by using the ELO method is performed to obtain the semiconductor substrate 10. Next, a step of forming the compound semiconductor part 9 is performed, then a step of forming the first and the second electrodes E1 and E2 is performed, and then a step of forming the first and the second pads P1 and P2 is performed. Thereafter, steps of etching the semiconductor substrate 10 from the back surface 1U of the main substrate 1, and forming the first hole H1 passing through the main substrate 1 in the semiconductor substrate 10 are performed. Thereafter, a step of forming the first wavelength conversion layer J1 in the first hole H1 is performed. When a through hole such as the first hole H1 is formed in the main substrate 1, the through hole can be formed by, for example, a technique such as wet etching or dry etching. More specifically, for example, the through hole may be formed by the Bosch method. The through holes such as the second hole H2 and the third hole H3 can also be formed by the above-described technique.

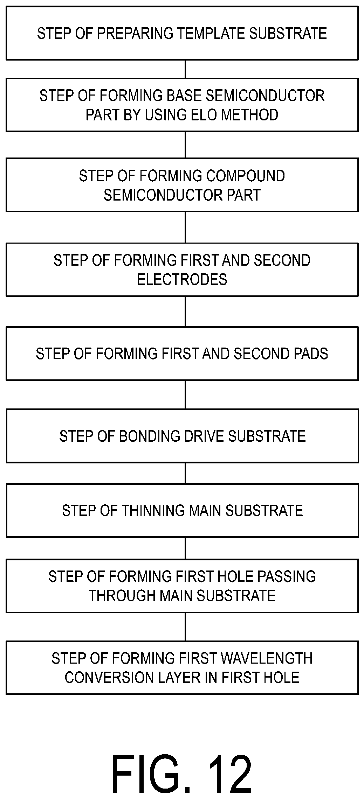

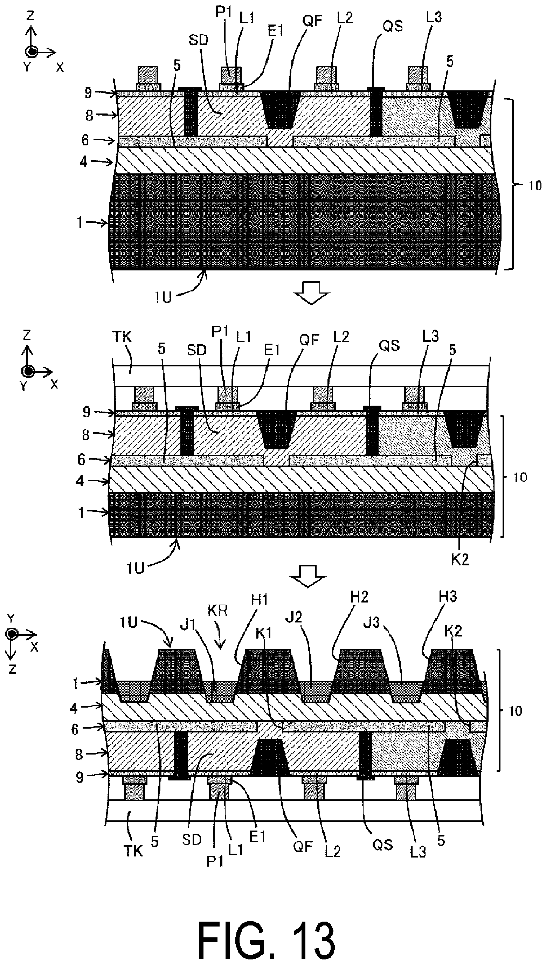

FIG. 12 is a flowchart illustrating another example of the method for manufacturing the light emitting device according to Example 1. FIG. 13 is a cross-sectional view illustrating the method for manufacturing the light emitting device illustrating in FIG. 12. As illustrated in FIGs. 12 and 13, after the step of forming the first and the second pads P1 and P2, the step of bonding the drive substrate TK may be performed, and then the main substrate 1 may be etched. For example, when a silicon substrate (generally from about 300 µm to about 2.0 mm thick) is used as the main substrate 1, it is not easy to form a through hole in the thick silicon substrate. Therefore, after the drive substrate TK is bonded to the opposite side of the silicon substrate, the silicon substrate (main substrate 1) may be thinned (to be for example, thickness of 300 µm or less) by a method such as wet etching, dry etching, polishing, or Chemical Mechanical Polishing (CMP), and then the through hole having the opening KR may be formed.

### Main Substrate

A heterogeneous substrate having a different lattice constant from that of a GaN-based semiconductor may be used for the main substrate 1. Examples of the heterogeneous substrate include a single crystal silicon (Si) substrate, a sapphire (Al₂O₃) substrate, and a silicon carbide (SiC) substrate. The plane orientation of the main substrate 1 is, for example, the (111) plane of the silicon substrate, the (0001) plane of the sapphire substrate, or the 6H-SiC (0001) plane of the SiC substrate. These are merely examples, and any main substrate and any plane orientation that allow the ELO base semiconductor part 8 to be grown by the ELO method is used.

### Underlying Portion

A buffer portion 2 and a seed portion 3 may be provided in this order from the main substrate 1 side, as the underlying portion 4. The buffer portion 2 may be a buffer layer. The seed portion 3 may be a seed layer. The buffer portion 2 has, for example, a function of reducing the likelihood of the main substrate 1 and the seed portion 3 coming into direct contact with each other and melting together. For example, when a silicon substrate is used for the main substrate 1 and a GaN-based semiconductor is used for the seed portion 3, these (the main substrate and the seed portion) melt together, and thus the melting is reduced by providing the buffer portion 2 including at least one of an AlN layer or a silicon carbide (SiC) layer. The AlN layer being an example of the buffer portion 2 can be formed using an MOCVD device, for example, to have a thickness of from about 10 nm to about 5 µm. The buffer portion 2 may have the effect of enhancing the crystallinity of the seed portion 3 and/or the effect of reducing the internal stress of the base semiconductor part 8 (reducing the warpage of the light emitting device 30). When using the main substrate 1 is unlikely to melt with the seed portion 3, a configuration without the buffer portion 2 may also be employed (that is, the underlying portion 4 may be configured by the seed portion). The underlying portion 4 is not limited to have the configuration in which the underlying portion 4 overlaps the entire mask portion 5 in plan view as in FIG. 5. Since the underlying portion 4 may be exposed from the opening portions K1 and K2 of the mask 6, the underlying portion 4 may be formed locally (for example, in a slit shape extending in the Y-direction) overlapping the opening portions K1 and K2 in plan view (described below).

The buffer portion 2 (for example, aluminum nitride, silicon carbide) and/or the seed portion 3 (for example, GaN-based semiconductor) may be film-formed using a sputtering device (PSD: pulse sputter deposition, PLD: pulse laser deposition, or the like). The use of a sputtering apparatus allows for low-temperature film formation and large-area film formation and has an advantage such as cost reduction.

### Mask

The opening portions K1 and K2 in the mask 6 function as growth initiation holes to expose the seed portion 3 and initiate the growth of the base semiconductor part 8. The mask portion 5 of the mask 6 functions as a mask for selective growth to laterally grow the base semiconductor part 8. The opening portions K1 and K2 are portions without the mask portion 5, and the opening portions K1 and K2 are not necessarily be surrounded by the mask portion 5.

Examples of the mask 6 that can be used include a single-layer film including any one of a silicon oxide film (SiOx), a titanium nitride film (TiN or the like), a silicon nitride film (SiNx), a silicon oxynitride film (SiON), and a metal film having a high melting point (for example, 1000°C or higher) or a layered film including at least two of these.

For example, a silicon oxide film having a thickness of from about 100 nm to about 4 µm (preferably from about 150 nm to about 2 µm) is formed on the entire surface of the underlying portion 4 by using sputtering, and a resist is applied onto the entire surface of the silicon oxide film. Subsequently, the resist is patterned by photolithography to form the resist with a plurality of stripe-shaped opening portions. Thereafter, part of the silicon oxide film is removed by a wet etchant such as hydrofluoric acid (HF), buffered hydrofluoric acid (BHF), or the like to form the plurality of opening portions (including K1 and K2), and the resist is removed by organic cleaning to form the mask 6. As another example, the silicon nitride film may be formed using a sputtering device or a Plasma Enhanced Chemical Vapor Deposition (PECVD) device. The silicon nitride film can withstand, even when being thinner than the silicon oxide film, the film formation temperature of the base semiconductor part 8 of about 1000°C. The thickness of the silicon nitride film may be from about 20 nm to about 4 µm.

The opening portions K1 and K2 have an elongated shape (slit shape) and is periodically arranged in an a-axis direction (X-direction) of the ELO base semiconductor part 8. The widths of the opening portions K1 and K2 are from about 0.1 µm to about 20 µm. As the width of each opening portion decreases, the number of threading dislocations propagating from each opening portion to the ELO base semiconductor part 8 decreases. A large second portion LD may be obtained.

The silicon oxide film may decompose and evaporate in minute amounts during film formation of the ELO base semiconductor part 8 and may be taken into the ELO base semiconductor part 8. However, a silicon nitride film and a silicon oxynitride film have the advantage of being difficult to decompose and evaporate at high temperatures.

The mask 6 may be a single-layer film of a silicon nitride film or a silicon oxynitride film, a layered film in which a silicon oxide film and a silicon nitride film are formed in this order on the underlying portion 4, a laminate body film in which a silicon nitride film and a silicon oxide film are formed in this order on the underlying portion 4, or a layered film in which a silicon nitride film, a silicon oxide film, and a silicon nitride film are formed in this order on the underlying portion.

An abnormal portion such as a pinhole in the mask portion 5 may be eliminated by performing organic cleaning or the like after film formation and introducing the film again into a film forming device to form the same type of film. A typical silicon oxide film (single layer) can also be used to form a good quality mask 6 by such a method to form the film again.

### Specific Example of Template Substrate

A silicon substrate having the (111) plane was used as the main substrate 1, and the buffer portion 2 of the underlying portion 4 was made an AlN layer (of from about 30 nm to about 300 nm, for example, 150 nm). The seed portion 3 of the underlying portion 4 was made a graded layer in which an Al_{0.6}Ga_{0.4}N layer (for example, 300 nm) as a first layer and a GaN layer (of for example, from 1 to 2 µm) as a second layer were formed in that order.

As the mask 6, a laminate body in which a silicon oxide film (SiO₂) and a silicon nitride film (SiN) were formed in that order was used. The silicon oxide film had a thickness of, for example, 0.3 µm, and the silicon nitride film had a thickness of, for example, 70 nm. Each of the silicon oxide film and the silicon nitride film was film-formed by a plasma chemical vapor deposition (CVD) method.

### Base Semiconductor Part

In Example 1, the GaN layer was provided as the base semiconductor part 8, and the ELO film of gallium nitride (GaN) was formed on the template substrate 7 described above using the MOCVD apparatus. The following may be adopted as examples of the ELO film formation conditions: substrate temperature: 1120°C, growth pressure: 50 kPa, trimethylgallium (TMG): 22 sccm, NH₃: 15 slm, and V/III = 6000 (ratio of supply amount of group V raw material to supply amount of group III raw material).

In this case, the first and the second regions 8F and 8S (base semiconductor part 8) are selectively grown (vertically grown) on the seed portion 3 (the GaN layer that is the second layer) exposed in the opening portions K1 and K2 and are subsequently laterally grown on the mask portion 5. The lateral growth was stopped before the first and the second regions 8F and 8S (base semiconductor part 8) laterally grown from both sides of the mask portion 5 met each other.

The width of the mask portion 5 (the size in the X-direction) was 50 µm, the width of the opening portions K1 and K2 (the size in the X-direction) was 5 µm, the lateral width (the size in the X-direction) of the ELO base semiconductor part 8 was 53 µm, the width of the second portion LD (the size in the X-direction) was 24 µm, and the thickness of the ELO base semiconductor part 8 was 5 µm. Thus, the aspect ratio of the ELO base semiconductor part 8 was 53 µm/5 µm = 10.6, achieving a very high aspect ratio. The width of the mask portion 5 can be set in accordance with the specifications of the compound semiconductor part 9 and the like (to be, for example, from about 10 µm to about 200 µm).

In Example 1, the lateral film formation rate is increased in the formation of the ELO base semiconductor part 8. A technique for increasing the lateral film formation rate is as follows. First, a vertical growth layer growing in the Z-direction (c-axis direction) is formed on the seed portion 3 exposed from the opening portions K1 and K2, followed by a lateral growth layer growing in the X-direction (a-axis direction). In this case, making the thickness of the vertical growth layer 10 µm or less, preferably 5 µm or less, and more preferably 3 µm or less allows the thickness of the lateral growth layer to be kept low and the lateral film formation rate to be increased.

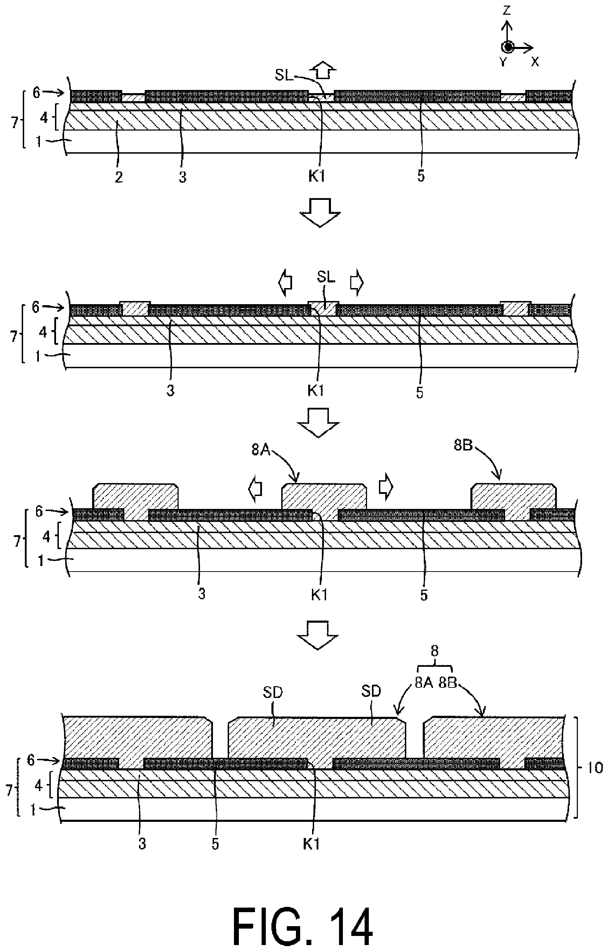

FIG. 14 is a cross-sectional view illustrating an example of the lateral growth of the base semiconductor part (ELO semiconductor layer). As illustrated in FIG. 14, preferably, an initial growth layer SL is formed on the seed portion 3, and then base semiconductor parts 8A and 8B are grown laterally from the initial growth layer SL. The initial growth layer SL serves as a start point of the lateral growth of the base semiconductor parts 8A and 8B. By appropriately controlling the ELO film formation conditions, the base semiconductor parts 8A and 8B can be controlled to grow in the Z-direction (c-axis direction) or in the X-direction (a-axis direction).

Here, preferably, the film formation of the initial growth layer SL is stopped at a timing immediately before an edge of the initial growth layer SL rides on the upper surface of the mask portion 5 (at a stage of being in contact with the upper end of a side surface of the mask portion 5) or immediately after the edge of the initial growth layer SL rides on the upper surface of the mask portion 5 (that is, at this timing, the ELO film formation condition is switched from the c-axis direction film formation condition to the a-axis direction film formation condition). In this way, lateral film formation is performed with the initial growth layer SL protruding slightly from the mask portion 5, reducing the amount of material consumed for growth in the thickness direction of the base semiconductor parts 8A and 8B and allowing the base semiconductor part 8 to be grown laterally at high speed. The initial growth layer SL may be formed to have a thickness of, for example, 0.1 µm or more and 4.0 µm or less.

### Compound Semiconductor Part and Electrode

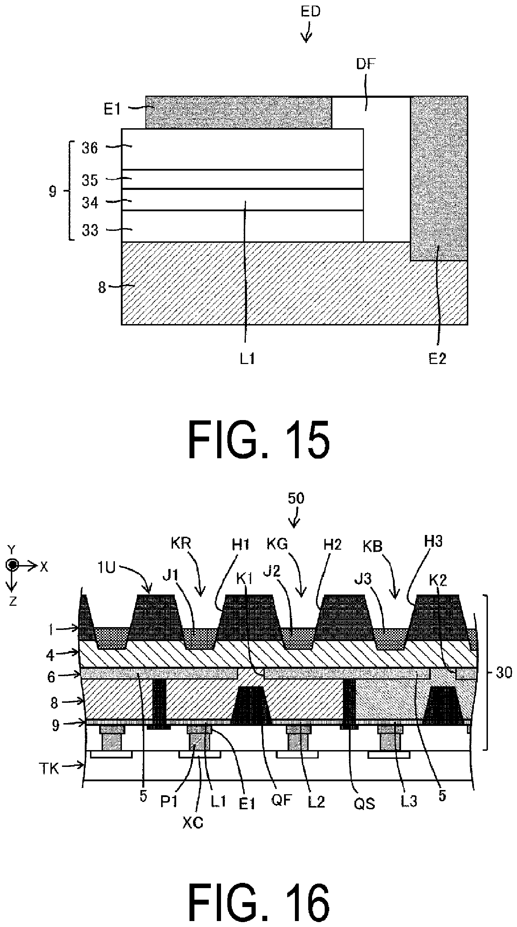

FIG. 15 is a schematic cross-sectional view illustrating a configuration of the base semiconductor part and the compound semiconductor part. In Example 1, the compound semiconductor part 9 constituting an LED (light emitting diode) is formed on the base semiconductor part 8. The base semiconductor part 8 is an n-type layer doped with, for example, silicon or the like. The compound semiconductor part 9 includes an active layer 34, an electron blocking layer 35, and a p-type semiconductor layer 36 in the order from the bottom layer side. The active layer 34 is a multi-quantum well (MQW) and includes an InGaN layer and a GaN layer. The active layer 34 includes the first light emitting portion L1. The electron blocking layer 35 is, for example, an AlGaN layer. The p-type semiconductor layer 36 is, for example, a p-type GaN layer. The first electrode E1 that is the anode is disposed in contact with the p-type semiconductor layer 36, and the second electrode E2 as the cathode is disposed in contact with the base semiconductor part 8. The first electrode E1, the base semiconductor part 8, the active layer 34, the electron blocking layer 35, the p-type semiconductor layer 36, and the second electrode E2 constitute a light-emitting element ED (so-called micro LED). An n-type semiconductor layer may be provided between the base semiconductor part 8 and the active layer 34.

The first electrode E1 and the second electrode E2 may have a single layer structure or a multilayer structure including at least one selected from the group consisting of Al, Ag, Cr, Pd, Pt, Au, Ni, Ti, V, W, Cu, Zn, Sn, and In and may include an alloy layer. When the emission wavelength of the compound semiconductor part 9 is shorter than 420 nm (when the emission spectrum includes light emitted with a wavelength shorter than 420 nm), the light reflectance can be improved with Ag included in at least one of the first electrode E1 or the second electrode E2. At least one of the first electrode E1 or the second electrode E2 can have a laminate structure of a light-transmissive conductive film, such as Indium Tin Oxide (ITO), on the compound semiconductor part 9 and a light-reflective metal film (such as Ag, Al, or Ti).

A protection layer DF has a function of electrically isolating the first and the second electrodes E1 and E2 from each other. The protection layer DF may have an effect of treating a side surface formed by removing part of the compound semiconductor part 9 by etching or the like or a damage layer formed on the side surface.

The base semiconductor part 8 (ELO semiconductor layer) and the compound semiconductor part 9 can be continuously formed by the same film forming apparatus (for example, MOCVD apparatus). Alternatively, the substrate on which the base semiconductor part 8 is formed may be taken out from the film forming apparatus and the compound semiconductor part 9 may be formed by another apparatus. In this case, the compound semiconductor part 9 may be formed after the n-type GaN layer (for example, having a thickness of from about 0.1 µm to about 3 µm) serving as a buffer during regrowth is formed on the base semiconductor part 8.

### Wavelength Conversion Layer

A material including at least one of a fluorescent material or a phosphorescent material can be used for the first to the third wavelength conversion layers J1 to J3. For example, using a material that converts ultraviolet light into blue light as the first wavelength conversion layer J1, using a material that converts ultraviolet light into green light as the second wavelength conversion layer J2, and using a material that converts ultraviolet light into red light as the third wavelength conversion layer J3 cause red light to be emitted from the opening (light emission plane) KR of the first hole H1, green light to be emitted from an opening (light emission plane) KG of the second hole H2, and blue light to be emitted from an opening (light emission plane) KB of the third hole H3. The first to the third wavelength conversion layers J1 to J3 can be formed using a photolithography method, an inkjet method, or the like.

For example, the first hole H1 formed in the semiconductor substrate 10 functions as a container for holding the first wavelength conversion layer J1 (including at least one of a fluorescent material or a phosphorescent material) in the first hole H1. The light from the active layer 34 is converted to have a desired wavelength by the first wavelength conversion layer J1 in the first hole H1. The minimum thickness of the first wavelength conversion layer J1 is determined by the properties (for example, particle shape, size, and conversion efficiency) of the fluorescent material/phosphorescent material used in the first wavelength conversion layer J1. While the main substrate 1 can be thinned by polishing after the formation of the base semiconductor part 8 and the compound semiconductor part 9, the final main substrate 1 preferably has a thickness that is larger than the minimum thickness of the first wavelength conversion layer J1. The same applies to the second and the third holes H2 and H3 and the second and third wavelength conversion layers J2 and J3.

### Display Device

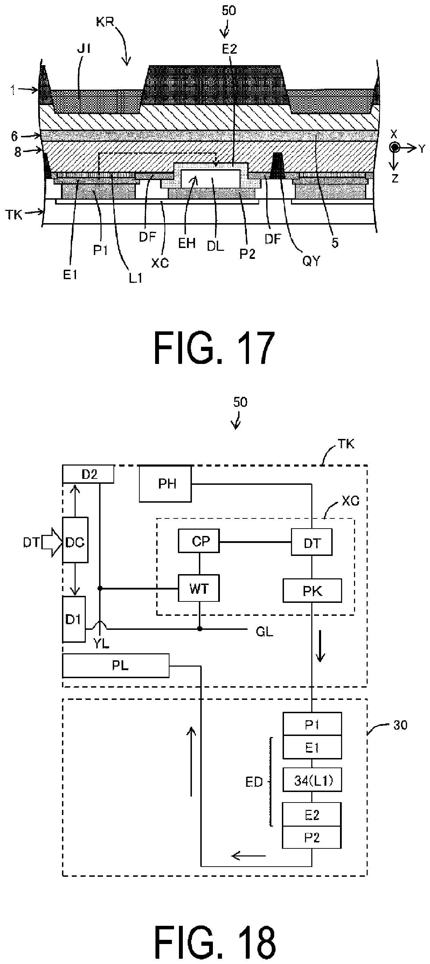

FIG. 16 and FIG. 17 are cross-sectional views each illustrating a configuration of the display device according to Example 1. FIG. 18 is a block diagram illustrating a configuration of the display device according to Example 1. As illustrated in FIG. 16 to FIG. 18, the display device 50 includes the light emitting device 30 and the drive substrate TK that is disposed on the side of the light emitting device 30 opposite to the main substrate 1 and is electrically connected to the first and the second pads P1 and P2. The drive substrate TK includes a high-potential-side power supply PH, a low-potential-side power supply PL, a plurality of pixel circuits XC, first and second driver circuits D1 and D2, and a control circuit DC. The pixel circuit XC includes, for example, a conductive pad PK, a write transistor WT, a drive transistor DT and a capacitor CP. The drive transistor DT controls the intensity of the light emitted from the first light emitting portion L1 (the current value of the light-emitting element ED).

When the light emitting device 30 is mounted on the drive substrate TK, the high-potential-side power supply PH of the drive substrate TK is connected to the conductive pad PK via a channel of the drive transistor DT, the conductive pad PK is connected to the first electrode E1 (anode) via the first pad P1, and the low-potential-side power supply PL of the drive substrate TK is connected to the second electrode E2 (cathode) via the second pad P2.

In the pixel circuit XC, while a scanning line GL is selected by a first driver D1 (scan driver), display voltage (voltage corresponding to gradation data DT) from a data line YL connected to a second driver D2 (data driver) is written to a capacitor CP via the write transistor WT, and the current corresponding to the display voltage flows to the second electrode E2 via the channel of the drive transistor DT, the conductive pad PK, the first pad P1, the first electrode E1, and the active layer 34. As a result, the first light emitting portion L1 of the active layer 34 emits light of intensity corresponding to the gradation data DT (image data input to the control circuit DC). The light (for example, ultraviolet light) from the first light emitting portion L1 is converted into visible light by the first wavelength conversion layer J1. As a result, visible light (for example, red light) of intensity corresponding to the gradation data DT. The same applies to the second and the third light emitting portions L2 and L3.

The drive substrate TK may include a silicon substrate, and the pixel circuit XC may be formed on the silicon substrate. In this case, the channel of each transistor (DT, WT, or the like) may include silicon (for example, amorphous silicon or polysilicon).

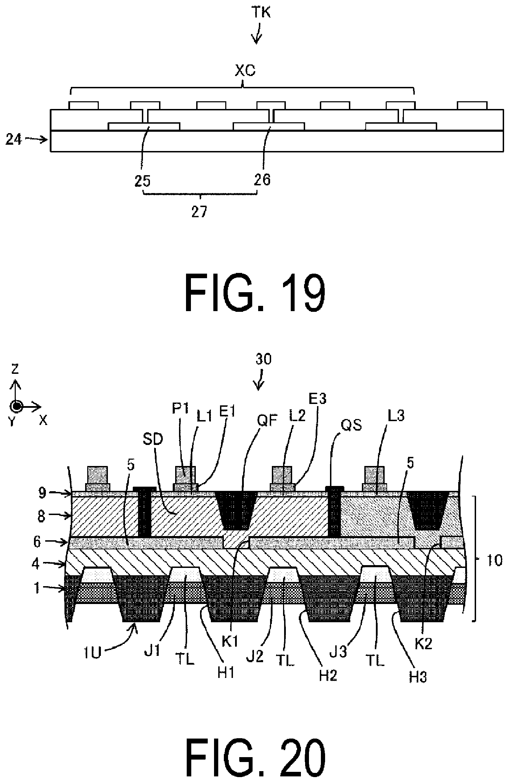

FIG. 19 is a cross-sectional view illustrating an example of the drive substrate. As illustrated in FIG. 19, the pixel circuit XC of the drive substrate TK may include a CMOS circuit 27 that is formed on a substrate 24 and include an n-channel MOS transistor 25 and a p-channel MOS transistor 26.

The main substrate 1 of the light emitting device 30 and the substrate 24 of the drive substrate TK may be made of the same material. For example, when a silicon substrate is used for each of the light emitting device 30 and the drive substrate TK (that is, the main substrate 1 and the substrate 24 of the drive substrate TK have the same thermal expansion coefficient), the bonding accuracy of the light emitting device 30 to the drive substrate TK is improved, and the yield is improved. The light emitting device 30 having a large light emission plane (display plane) can be bonded to the drive substrate TK.

The display device 50 of Example 1 can use the opening KR of the first hole H1 as a light emission plane for a red sub-pixel, the opening KG of the second hole H2 as a light emission plane for a green sub-pixel, and the opening KB of the third hole H3 as a light emission plane for a blue sub-pixel, and these three sub-pixels constitute one pixel. As one example, when the lateral width of the first region 8F (base semiconductor part 8) is made about 53 µm, the sub-pixel pitch in the X-direction is made about 28 µm, and the sub-pixel pitch in the Y-direction is made about 84 µm, a display device (micro LED display) having the number of pixels per inch (PPI) of about 900 can be formed.

According to Example 1, even using a heterogeneous substrate for the main substrate 1 allows the crystallinity of the first light emitting portion L1 located above, for example, the first hole H1 forming region to be improved and the light emission efficiency of the first light emitting portion L1 to be improved. For example, forming part of the first hole H1 in the main substrate 1 as a growth substrate allows the first hole H1 to function as a container for holding the first wavelength conversion layer J1 and the main substrate 1 (for example, a silicon substrate) having low light transmittance to function as a light shielding structure for reducing the crosstalk phenomenon (optical interference between adjacent light emitting portions). This simplifies the structure of extracting light generated in the first light emitting portion L1 and improves the extraction efficiency.

### Example 2

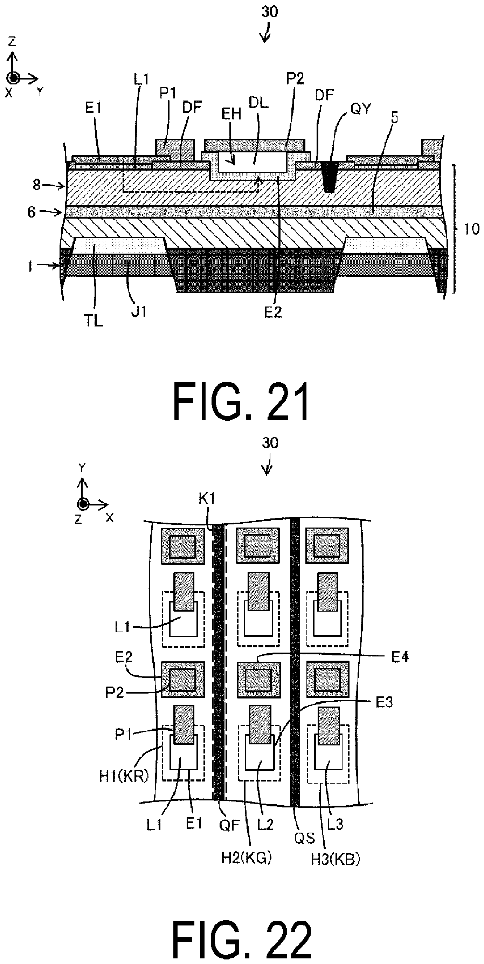

FIG. 20 is a cross-sectional view of a light emitting device according to Example 2 taken along the X-direction. FIG. 21 is a cross-sectional view of the light emitting device according to Example 2 taken along the Y-direction. FIG. 22 is a plan view of the light emitting device according to Example 2. In the light emitting device 30 according to Example 2, the underlying portion 4 includes at least part of the bottom portion of the first hole H1, and a transparent resin layer TL in contact with the bottom portion of the first hole H1 and the first wavelength conversion layer J1 are provided in the first hole H1. The transparent resin layer TL and the first wavelength conversion layer J1 are in contact with each other, and a contact surface between the transparent resin layer TL and the first wavelength conversion layer J1 is located in the main substrate 1. A material having an index of refraction smaller than that of the underlying portion 4 can be used for the transparent resin layer TL. The same applies to the second and the third holes H2 and H3. This can suppress incidence of light (stray light) propagating into the underlying portion 4 onto the first to the third wavelength conversion layers J1 to J3.

In Example 2, at least part of the first pad P1 does not overlap the first hole H1 in plan view, as illustrated in FIG. 21 and FIG. 22. This can reduce the impact of the pressing onto the first pad P1 on the compound semiconductor part 9 and the base semiconductor part 8. At least part of the first pad P1 does not overlap the first light emitting portion L1. This can reduce the impact of the pressing onto the first pad P1 on the compound semiconductor part 9 and the first light emitting portion L1. A configuration in which the first pad P1 does not contact the base semiconductor part 8 and the insulating film DF is located between the first pad P1 and the base semiconductor part 8 can be employed. This can prevent formation of a short-circuit path. The insulating film DF may be transparent.

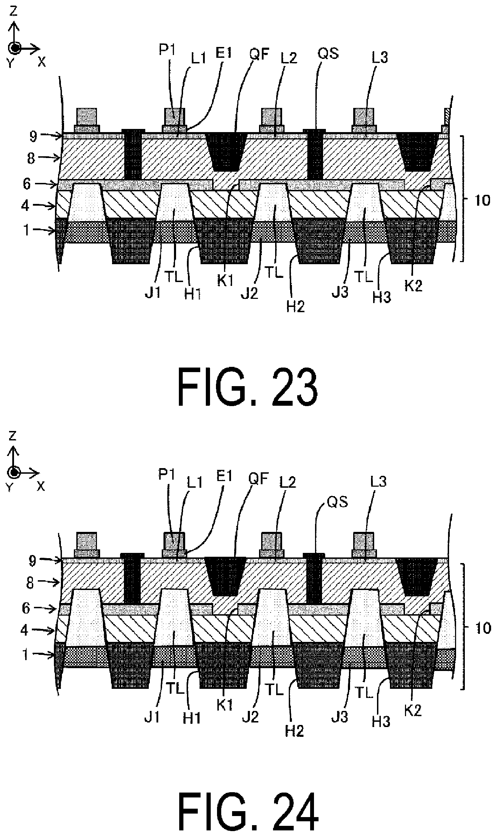

FIG. 23 and FIG. 24 are cross-sectional views each illustrating another configuration of the light emitting device according to Example 2. In the light emitting device 30 in FIG. 23, the mask 6 includes at least part of the bottom portion of the first hole H1. This can suppress incidence of light (stray light) propagating into the underlying portion 4 onto the first to the third wavelength conversion layers J1 to J3.

In the light emitting device 30 in FIG. 24, the first hole H1 passes through the mask 6, and the base semiconductor part 8 includes at least part of the bottom portion of the first hole H1. Note that the bottom portion of the first hole H1 may be the lower surface of the base semiconductor part 8. A material having an index of refraction smaller than that of the mask 6 can be used for the transparent resin layer TL. This can suppress incidence of light (stray light) propagating into the mask 6 onto the first to the third wavelength conversion layers J1 to J3. For example, an optical path from the first light emitting portion L1 to the bottom portion of the hole H1 involves no variation in the index of refraction. Therefore, the light emitted from the first light emitting portion L1 is less likely to be reflected or scattered in the optical path and efficiently reaches the hole H1, thus improving efficiency of extracting light.

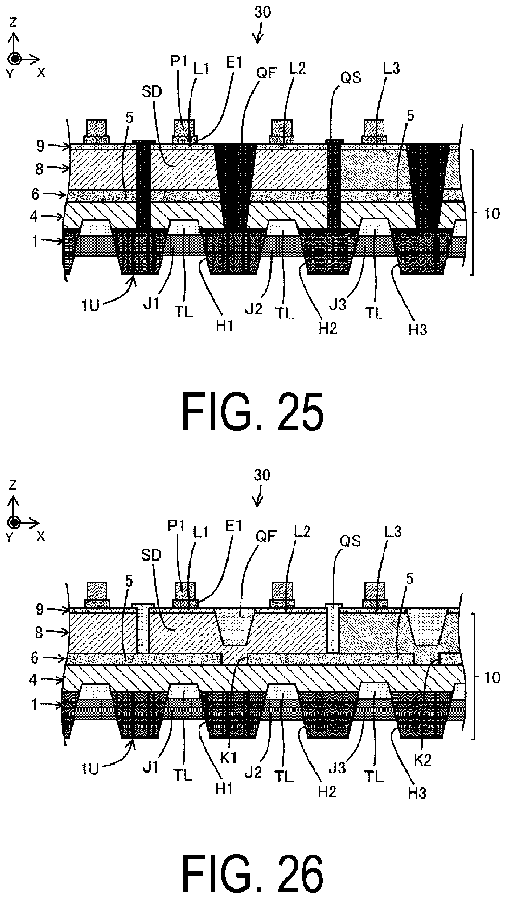

FIG. 25 is a cross-sectional view illustrating another configuration of the light emitting device according to Example 2. In FIG. 20 and the like, the bottom surface of the first partition wall portion QF is located in the base semiconductor part 8, and the bottom surface of the second partition wall portion QS is located in the upper surface of the mask portion 5, but the configuration is not limited thereto. As illustrated in FIG. 25, a configuration in which the first and the second partition wall portions QF and QS having light shielding property pass through the mask 6 and the underlying portion 4 to reach the upper surface of the main substrate 1 can be employed.

FIG. 26 is a cross-sectional view illustrating another configuration of the light emitting device according to Example 2. In FIG. 20 and the like, the first and the second partition wall portions QF and QS have light shielding property, but the configuration is not limited thereto. As illustrated in FIG. 26, the first and the second partition wall portions QF and QS may be made of a light transmitting material having an index of refraction for the emission wavelength of each light emitting portion lower than that of the base semiconductor part 8. This causes light incident on the first and the second partition wall portions QF and QS at an angle exceeding the critical angle to be totally reflected, allowing propagation of light (stray light) in the base semiconductor part 8 to be suppressed.

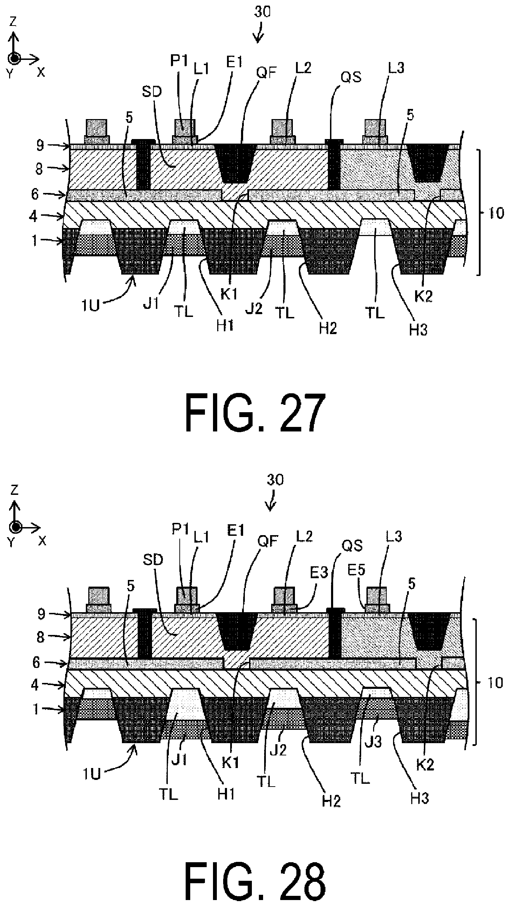

FIG. 27 is a cross-sectional view illustrating another configuration of the light emitting device according to Example 2. In FIG. 20 and the like, the first to the third wavelength conversion layers J1 to J3 are provided, but the configuration is not limited thereto. As illustrated in, for example, FIG. 27, a configuration of making the emission wavelengths of the first to the third light emitting portions L1 to L3 in the blue range, providing no wavelength conversion layer in the third hole H3, and emitting the blue light from the third light emitting portion L3 from the third hole H3 can be employed. The third hole H3 may be provided with the transparent resin layer TL.

FIG. 28 is a cross-sectional view illustrating another configuration of the light emitting device according to Example 2. As illustrated in FIG. 28, providing the third electrode E3 (light-reflecting electrode) overlapping the second light emitting portion L2 in plan view allows the distance between the first electrode E1 (light-reflecting electrode) and the first wavelength conversion layer J1 to be made larger than the distance between the third electrode E3 and the second wavelength conversion layer J2. In this case, the transparent resin layer TL in the first hole H1 may be thicker than the transparent resin layer TL in the second hole H2, or the depth of the first hole H1 may be smaller than the depth of the second hole H2.

Providing a fifth electrode E5 (light-reflecting electrode) overlapping the third light emitting portion L3 in plan view allows the distance between the third electrode E3 and the second wavelength conversion layer J2 to be made larger than the distance between the fifth electrode E5 and the third wavelength conversion layer J3. This can obtain an optical resonance effect when the emission wavelength of the first wavelength conversion layer J1 is greater than the emission wavelength of the second wavelength conversion layer J2 and the emission wavelength of the second wavelength conversion layer J2 is greater than the emission wavelength of the third wavelength conversion layer J3 holds.

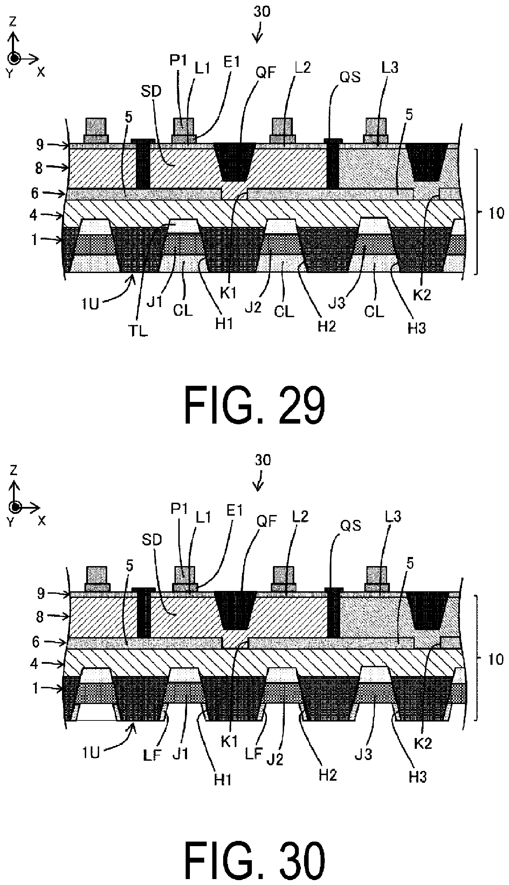

FIG. 29 is a cross-sectional view illustrating another configuration of the light emitting device according to Example 2. As illustrated in FIG. 29, an optical layer CL located on the light emission surface side from the first wavelength conversion J1 may be provided in the first hole H1. The optical layer CL may have at least one of a light diffusing function or a polarizing function. For example, when the optical layer CL has the light diffusing function, the viewing angle characteristics are improved (a change in luminance depending on a viewing angle is reduced). When the optical layer CL has the polarizing function (for example, a circular polarizing function), the impact of external light can be reduced.

FIG. 30 is a cross-sectional view illustrating another configuration of the light emitting device according to Example 2. As illustrated in FIG. 30, in the first hole H1, for example, a light reflection film LF (for example, a metal film) may be provided on a hole wall located on the light emission surface side from the first wavelength conversion J1. This can improve the light utilization efficiency.

### Example 3

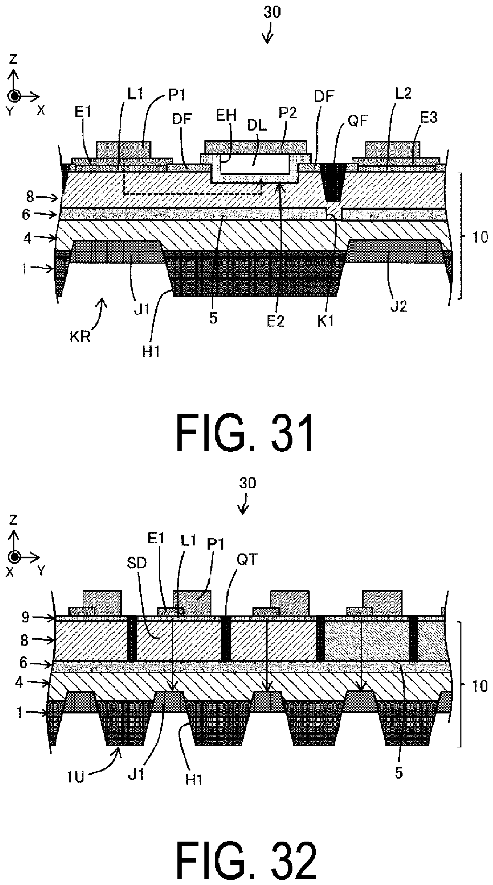

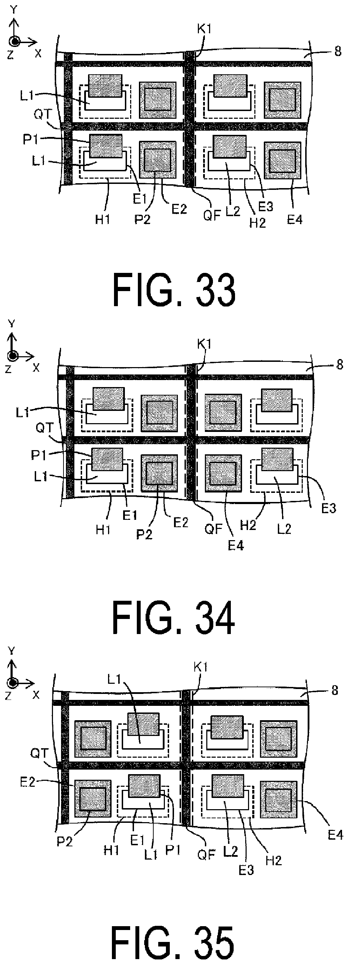

FIG. 31 is a cross-sectional view of a light emitting device according to Example 3 taken along the X-direction. FIG. 32 is a cross-sectional view of the light emitting device according to Example 3 taken along the Y-direction. FIG. 33 is a plan view of the light emitting device according to Example 3. As illustrated in FIGs. 31 to 33, the first and the second light emitting portions L1 and L2 are adjacent to each other in the X-direction, the first electrode E1 is an anode (p-electrode) overlapping the first light emitting portion L1 in plan view, the second electrode E2 is a cathode (n-electrode) adjacent to the first electrode E1 in the X-direction, the third electrode E3 is an anode overlapping the second light emitting portion L2 in plan view, and the fourth electrode E4 is a cathode adjacent to the third electrode E3 in the X-direction. In Example 3, the first electrode E1, the second electrode E2, the third electrode E3, and the fourth electrode E4 are aligned in this order in the X-direction, that is, the <11-20> direction of the base semiconductor part 8 including the GaN-based semiconductor, and the anodes are not adjacent to each other in the X-direction.

In plan view, the first electrode E1 overlaps the second portion SD (portion located on the mask portion 5) of the base semiconductor part 8, and at least part of the first pad P1 connected to the first electrode E1 does not overlap the first hole H1.

In plan view, the opening portion K1 of the mask 6 is located between the first and the second light emitting portions L1 and L2, the first partition wall portion QF is located overlapping the opening portion K1, and the third partition wall portion QT extending in the X-direction is located between the first light emitting portions L1 adjacent to each other in the Y-direction. The third partition wall portion QT may have a light shielding property or may have an index of refraction lower than that of the base semiconductor part 8.

FIG. 34 and FIG. 35 are cross-sectional views each illustrating another configuration of the light emitting device according to Example 3. In FIG. 34, the first electrode E1, the second electrode E2, the fourth electrode E4, and the third electrode E3 are aligned in this order in the X-direction, and the cathodes are adjacent to each other in the X-direction. In FIG. 35, the second electrode E2, the first electrode E1, the third electrode E3, and the fourth electrode E4 are aligned in this order in the X-direction, and the anodes are adjacent to each other in the X-direction.

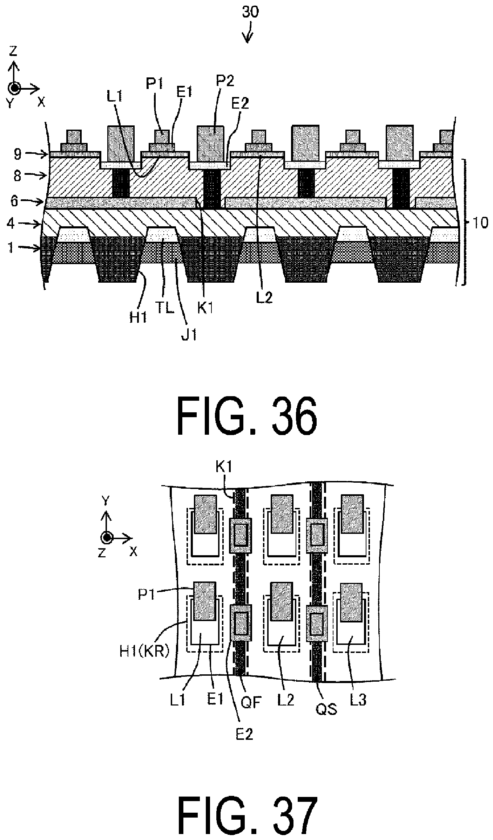

FIG. 36 is a cross-sectional view illustrating another configuration of the light emitting device according to Example 3. FIG. 37 is a plan view illustrating another configuration of the light emitting device according to Example 3. As illustrated in FIG. 36 and FIG. 37, the second electrode E2 that is the cathode may be provided overlapping the opening portion K1 of the mask 6 in plan view. The first light emitting portion L1 overlaps the second portion LD in plan view, and the first electrode E1 overlaps the first light emitting portion L1 in plan view.

In FIG. 36 and FIG. 37, the first and the second electrodes E1 and E2 are aligned in the X-direction. The first and the second electrodes E1 and E2 have light reflectivity. In plan view, at least part of the first pad P1 does not overlap the first hole H1, and at least part of the second pad P2 does not overlap the first hole H1.

### Example 4

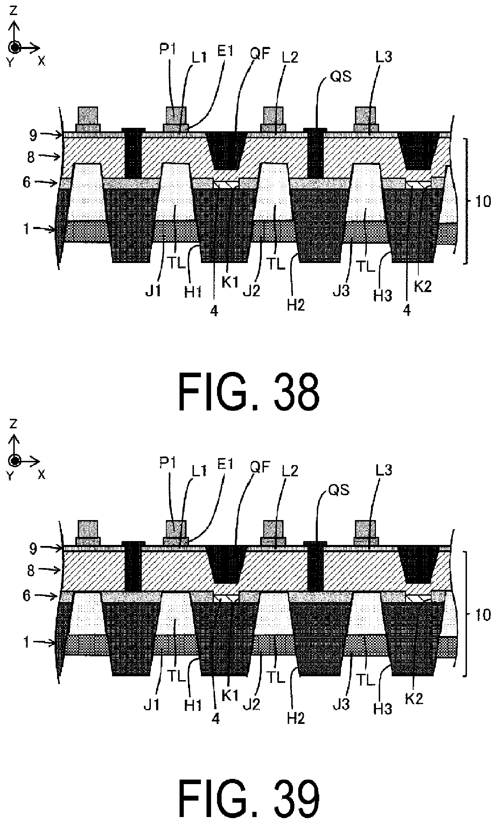

FIG. 38 and FIG. 39 are cross-sectional views each illustrating another configuration of the light emitting device according to Example 4. In FIG. 38, the underlying portion 4 is locally provided overlapping the opening portion K1 of the mask 6 in plan view. For example, this is achieved with a pattern shape overlapping the opening portion K1, such as a slit shape extending in the Y-direction. The base semiconductor part 8 includes the bottom portion of the first hole H1. Providing the underlying portion 4 locally allows the warpage of the light emitting device 30 to be reduced and the bonding accuracy to the drive substrate TK to be improved. The main substrate 1 may be a silicon substrate and the locally provided underlying portion 4 may include a buffer portion (including, for example, at least one of AlN or SiC) and the seed portion (GaN-based semiconductor), or the main substrate 1 may be a silicon substrate, and the local underlying portion 4 may include the seed portion (for example, AlN or 6H-SiC). As in FIG. 39, the lower surface of the base semiconductor part 8 may be the bottom portion of the first hole H1.

### Example 5

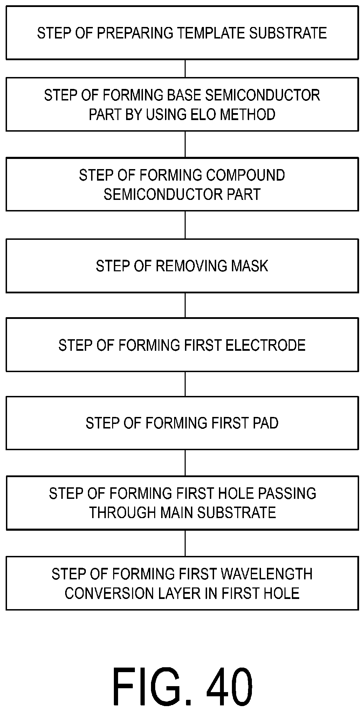

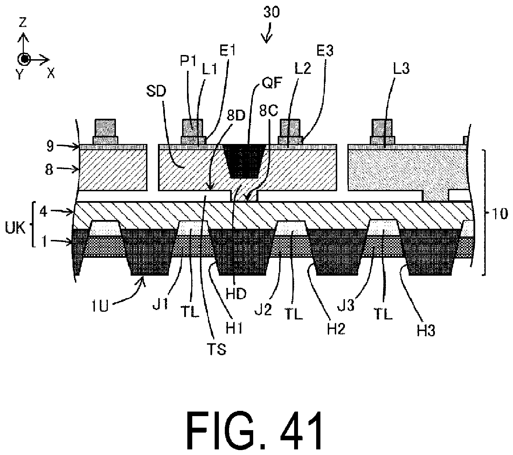

FIG. 40 is a flowchart illustrating a method for manufacturing a light emitting device according to Example 5. FIG. 41 is a cross-sectional view illustrating a configuration of the light emitting device according to Example 5. In Examples 1 to 4, the light emitting device 30 includes the mask 6, but the configuration is not limited thereto. As illustrated in FIG. 40, the mask may be removed after the compound semiconductor part 9 is formed on the semiconductor substrate 10 including the mask. The mask can be removed by, for example, wet etching using an etchant such as hydrofluoric acid or buffered hydrofluoric acid. The light emitting device 30 in FIG. 41 includes the semiconductor substrate 10 including the underlying substrate UK including the main substrate 1 and the base semiconductor part 8 located above the underlying substrate UK and the compound semiconductor part 9 located above the semiconductor substrate 10 and including the first light emitting portion L1. The semiconductor substrate 10 includes no mask. Although the mask is removed before the electrode is formed in the present embodiment, the mask may be removed by a method such as wet etching after the electrode is formed while protecting the electrode using a resist or the like.

The base semiconductor part 8 includes a connection region 8C in contact with the underlying substrate UK and a non-connection region (non-contact region) 8D separated from the underlying substrate UK. The semiconductor substrate 10 includes a first hole H1 passing through the main substrate 1 in the thickness direction (Z-direction) and overlapping the first light emitting portion L1 in plan view below the first light emitting portion L1. The first light emitting portion L1 overlaps the non-connection region 8D in plan view above the non-connection region 8D.

The base semiconductor part 8 includes the first portion HD and the second portion SD having a density of the dislocation extending in the thickness direction (Z-direction) lower than the first portion HD. The first light emitting portion L1 overlaps the second portion SD in plan view above the second portion SD.

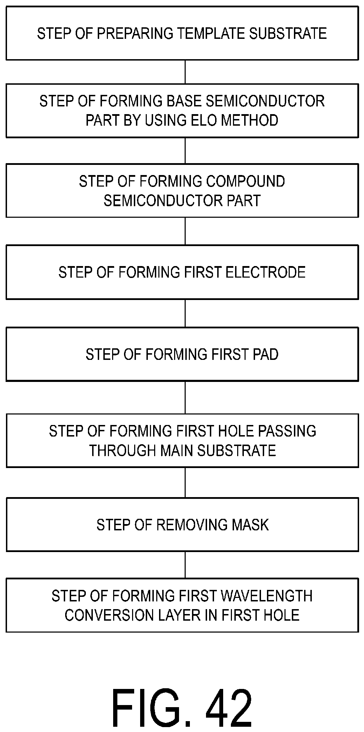

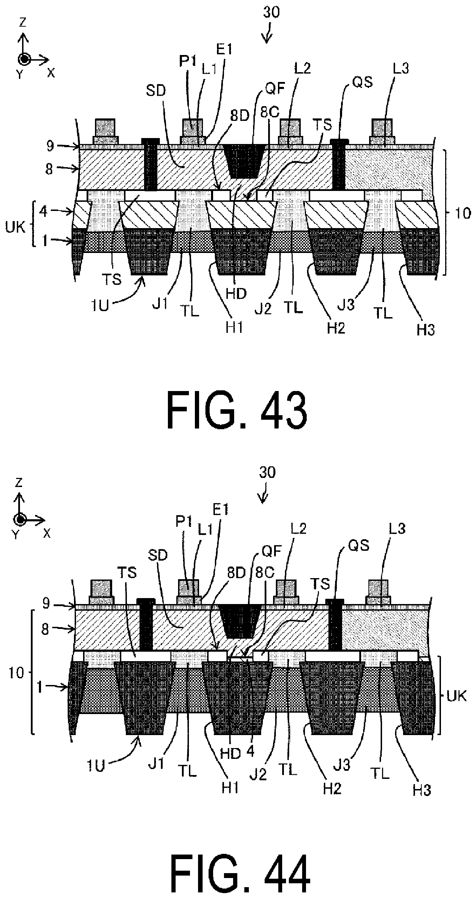

FIG. 42 is a flowchart illustrating another method for manufacturing the light emitting device according to Example 5. FIG. 43 is a cross-sectional view illustrating another configuration of the light emitting device according to Example 5. In FIG. 42, the compound semiconductor part 9 is formed on the semiconductor substrate 10 including the mask, the first electrode E1 and the first pad P1 are formed, the first hole H1 passing through the main substrate 1 is formed, and then the mask of the semiconductor substrate 10 is removed by etching or the like. Thereafter, the first wavelength conversion layer J1 is formed in the first hole H1. In the light emitting device 30 in FIG. 43, part of the transparent resin layer TL is disposed in a hollow portion TS formed as a result of the removal of the mask, the lower surface of the base semiconductor part 8 is in contact with the transparent resin layer TL and the hollow portion TS, and the underlying portion 4 of the underlying substrate UK is in contact with the hollow portion TS. The remaining part of the transparent resin layer TL and the first wavelength conversion layer J1 are provided in the first hole H1. The first light emitting portion L1 overlaps the non-connection region 8D in plan view above the non-connection region 8D, and the first light emitting portion L1 overlaps the second portion SD in plan view above the second portion SD.

FIG. 44 is a cross-sectional view illustrating another configuration of the light emitting device according to Example 5. In the light emitting device 30 in FIG. 44, the underlying portion 4 is locally arranged in a slit shape, and for example, the bottom portion of the first hole H1 is located in the lower surface of the base semiconductor part 8. In this case, after the first hole H1 reaching the lower surface of the base semiconductor part 8 is formed in the semiconductor substrate 10, the mask 6 is removed by etching or the like to expose the bottom portion of the base semiconductor part 8. The first light emitting portion L1 overlaps the non-connection region 8D in plan view above the non-connection region 8D, and the first light emitting portion L1 overlaps the second portion SD in plan view above the second portion SD. In this case, the step of removing the underlying portion 4 is not required, whereby the process is shortened. The distance (in the Z-direction) from the first light emitting portion L1 to the bottom portion of the first hole H1 is made short, thus improving the efficiency of extracting light from the first hole H1.

### Example 6

In Examples 1 to 5, the base semiconductor part 8 is a GaN layer, but the configuration is not limited thereto. The base semiconductor part 8 in Examples 1 to 5 may be an InGaN layer as a GaN-based semiconductor layer. The lateral film formation of the InGaN layer is performed at a low temperature below 1000°C, for example. This is because the vapor pressure of indium increases at a high temperature and indium is not effectively taken into the film. When the film formation temperature is low, an effect is exhibited in which the interaction between the mask portion 5 and the InGaN layer is reduced. The InGaN layer has an effect of exhibiting lower reactivity with the mask portion 5 than the GaN layer. When indium is taken into the InGaN layer at an In composition level of 1% or more, the reactivity with the mask portion 5 is further lowered, which is desirable. As the gallium raw material gas, triethylgallium (TEG) is preferably used.

### Example 7

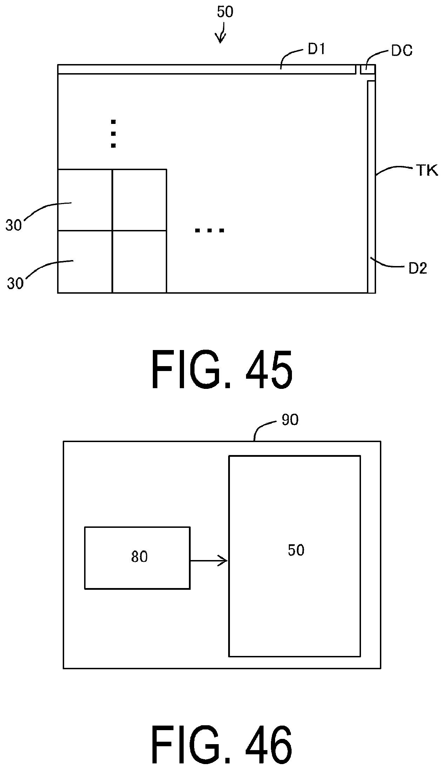

FIG. 45 is a schematic plan view illustrating a display device of Example 7. As illustrated in FIG. 45, the display device 50 may be formed with a plurality of the light emitting devices 30 of Examples 1 to 6 arranged and mounted on the drive substrate TK. The plurality of light emitting devices 30 may be arranged in a matrix. The drive substrate TK may include a control circuit DC that controls the first and the second driver circuits D1 and D2 and the control circuit for controlling these (see FIG. 18). This enables a large display device to be manufactured with high yield.

### Example 8

FIG. 46 is a schematic diagram illustrating a configuration of an electronic device according to Example 8. An electronic device 90 in FIG. 46 includes the display device 50 including the light emitting device 30 of Examples 1 to 6 and a controller 80 including a processor. Examples of the electronic device 90 include a communication device, an information processing device, a medical device, an electric vehicle (EV), a monitor, and a television set.

The description in the foregoing embodiments and examples have been presented for purposes of illustration and description, and limitation is not intended. Based on these illustrations and descriptions, it will be apparent to those skilled in the art that many variations are possible.

### Supplementary Note

In the present disclosure, the invention has been described above based on the various drawings and examples. However, the invention according to the present disclosure is not limited to each embodiment described above. That is, the embodiments of the invention according to the present disclosure can be modified in various ways within the scope illustrated in the present disclosure, and embodiments obtained by appropriately combining the technical means disclosed in different embodiments are also included in the technical scope of the invention according to the present disclosure. In other words, a person skilled in the art can easily make various variations or modifications based on the present disclosure. Note that these variations or modifications are included within the scope of the present disclosure.

### REFERENCE SIGNS

1 Main substrate
4 Underlying portion
5 Mask portion
6 Mask
8 Base semiconductor part
9 Compound semiconductor part
10 Semiconductor substrate
30 Light emitting device
50 Display device
L1 First light emitting portion
L2 Second light emitting portion
K1, K2 Opening portion
E1 First electrode
E2 Second electrode
J1 First wavelength conversion layer
H1 First hole
H2 Second hole
TK Drive substrate
UK Underlying substrate

## Claims

1. A light emitting device, comprising:
a semiconductor substrate comprising a main substrate, a mask located above the main substrate and comprising a mask portion and an opening portion, and a base semiconductor part located above the mask; and
a compound semiconductor part located above the semiconductor substrate and comprising a first light emitting portion,
wherein the semiconductor substrate comprises a first hole passing through the main substrate in a thickness direction and overlapping the first light emitting portion below the first light emitting portion.

2. The light emitting device according to claim 1, wherein the first light emitting portion overlaps the mask portion in plan view.

3. The light emitting device according to claim 1, wherein the first hole overlaps the mask portion in plan view.

4. The light emitting device according to claim 1, further comprising a first wavelength conversion layer disposed in the first hole and configured to emit light having a wavelength longer than a wavelength of received light.

5. The light emitting device according to any one of claims 1 to 4, further comprising
an underlying portion located on the main substrate,
wherein
the underlying portion comprises at least part of a bottom portion of the first hole.

6. The light emitting device according to any one of claims 1 to 4, wherein the mask comprises at least part of a bottom portion of the first hole.

7. The light emitting device according to any one of claims 1 to 4,
wherein the first hole penetrates passes through the mask, and
the base semiconductor part comprises at least part of a bottom portion of the first hole.

8. The light emitting device according to any one of claims 1 to 7, further comprising
a first electrode and a second electrode,
wherein the first electrode overlaps the first light emitting portion in plan view.

9. The light emitting device according to claim 8, wherein the first electrode has light reflectivity.

10. The light emitting device according to claim 8 or 9, further comprising:
a first pad connected to the first electrode; and
a second pad connected to the second electrode.

11. The light emitting device according to claim 10, wherein at least part of the first pad does not overlap the first hole.

12. The light emitting device according to claim 10 or 11, wherein at least part of the first pad does not overlap the first light emitting portion.

13. The light emitting device according to any one of claims 10 to 12, wherein at least part of the second pad does not overlap the first hole in plan view.

14. The light emitting device according to any one of claims 10 to 13, wherein a position of an upper surface of the first pad matches a position of an upper surface of the second pad.

15. The light emitting device according to any one of claims 8 to 14, wherein the second electrode overlaps the opening portion of the mask in plan view.

16. The light emitting device according to any one of claims 8 to 15, wherein the second electrode is in contact with the base semiconductor part.

17. The light emitting device according to any one of claims 8 to 16, wherein the second electrode has a recessed portion, and an insulating layer is provided in the recessed portion.

18. The light emitting device according to any one of claims 8 to 17,
wherein the first electrode is an anode, and
the second electrode is a cathode.

19. The light emitting device according to any one of claims 8 to 18,
wherein the base semiconductor part comprises a GaN-based semiconductor, and
the first electrode and the second electrode are aligned in a <1-100> direction of the GaN-based semiconductor.

20. The light emitting device according to any one of claims 8 to 18,
wherein the base semiconductor part comprises a GaN-based semiconductor, and
the first electrode and the second electrode are aligned in a <11-20> direction of the GaN-based semiconductor.

21. The light emitting device according to claim 4, wherein a transparent resin layer is disposed in a gap between a bottom portion of the first hole and the first wavelength conversion layer.

22. The light emitting device according to claim 21, wherein a contact surface between the transparent resin layer and the first wavelength conversion layer is located in the main substrate.

23. The light emitting device according to any one of claims 1 to 22,
wherein the base semiconductor part comprises a first portion located on the opening portion and a second portion located on the mask portion and having a threading dislocation density of 5 × 10⁶/cm² or lower, and
the second portion overlaps the first light emitting portion in plan view.

24. The light emitting device according to claim 8, further comprising a third electrode and a fourth electrode,
wherein the compound semiconductor part comprises a second light emitting portion,
the main substrate comprises a second hole that is a through hole formed in a thickness direction and overlaps the second light emitting portion in plan view, and
the third electrode overlaps the second light emitting portion in plan view.

25. The light emitting device according to claim 24,
wherein the base semiconductor part comprises a GaN-based semiconductor, and
the first electrode, the second electrode, the third electrode, and the fourth electrode are aligned in this order in a <11-20> direction of the GaN-based semiconductor.

26. The light emitting device according to claim 24,
wherein the base semiconductor part comprises a GaN-based semiconductor, and
the second electrode, the first electrode, the fourth electrode, and the third electrode are aligned in this order in a <11-20> direction of the GaN-based semiconductor.

27. The light emitting device according to any one of claims 1 to 26,
wherein the compound semiconductor part comprises a second light emitting portion and a third light emitting portion, and
the main substrate comprises a second hole that is a through hole in the thickness direction and overlaps the second light emitting portion in plan view and a third hole a through hole that is a through hole in the thickness direction and overlaps the third light emitting portion in plan view.

28. The light emitting device according to claim 27,
wherein the second hole is provided with a second wavelength conversion layer configured to emit light having a wavelength longer than a wavelength of received light, and
light having a color different from each other is emitted from each of the first to the third holes.

29. The light emitting device according to claim 27 or 28, wherein an emission peak wavelength of each of the first to the third light emitting portions is in a wavelength range from 430 to 640 [nm].

30. The light emitting device according to any one of claims 27 to 29, wherein the third hole is provided with a third wavelength conversion layer configured to emit light having a wavelength longer than a wavelength of received light.

31. The light emitting device according to any one of claims 27 to 29,
wherein the third hole is not provided with a wavelength conversion layer, and
blue light is emitted from the third hole.

32. The light emitting device according to any one of claims 27 to 31, further comprising
a first partition wall portion located in a gap between the first light emitting portion and the second light emitting portion in plan view.

33. The light emitting device according to claim 32, wherein the first partition wall portion overlaps the opening portion of the mask in plan view.

34. The light emitting device according to claim 32 or 33 wherein the first partition wall portion has a light shielding property or an index of refraction lower than that of the base semiconductor part.

35. The light emitting device according to any one of claims 27 to 34, further comprising
a second partition wall portion located in a gap between the second light emitting portion and the third light emitting portion in plan view.

36. The light emitting device according to claim 35, wherein the second partition wall portion overlaps a center of the mask portion in plan view.

37. The light emitting device according to claim 35 or 36 wherein the second partition wall portion has a light shielding property or an index of refraction lower than that of the base semiconductor part.

38. The light emitting device according to any one of claims 1 to 37,
wherein the base semiconductor part comprises a plurality of regions separated from each other, and
each of the plurality of regions has an elongated shape.

39. The light emitting device according to any one of claims 1 to 38, wherein the base semiconductor part and the compound semiconductor part each comprise a GaN-based semiconductor.

40. The light emitting device according to claim 39, wherein the main substrate is a heterogeneous substrate having a lattice constant different from that of the GaN-based semiconductor.

41. The light emitting device of claim 40, wherein the main substrate has a light shielding property.

42. The light emitting device according to 40 or 41, wherein the heterogeneous substrate is a silicon substrate.

43. The light emitting device according to any one of claims 1 to 42, wherein the first hole has a tapered shape tapered toward a side of the base semiconductor part.

44. The light emitting device according to claim 4, wherein the first wavelength conversion layer comprises at least one of a fluorescent material or a phosphorescent material.

45. The light emitting device according to claim 4, wherein the first hole is provided with an optical layer located on a light emission surface side from the first wavelength conversion layer.

46. The light emitting device according to claim 45, wherein the optical layer has at least one of a light diffusing function or a polarizing function.

47. The light emitting device according to any one of claims 1 to 46, wherein a light reflection film is provided on at least part of a hole wall of the first hole.

48. The light emitting device according to claim 24,
wherein the first hole is provided with a first wavelength conversion layer configured to emit light having a wavelength longer than a wavelength of received light,
the second hole is provided with a second wavelength conversion layer configured to emit light having a wavelength longer than a wavelength of received light,
an emission wavelength of the first wavelength conversion layer is longer than an emission wavelength of the second wavelength conversion layer, and
a distance between the first electrode and the first wavelength conversion layer is larger than a distance between the third electrode and the second wavelength conversion layer.

49. The light emitting device according to claim 11 or 12, wherein a transparent insulating film is disposed between the first pad and the base semiconductor part.

50. The light emitting device according to any one of claims 1 to 4, further comprising
an underlying portion located on the main substrate,
wherein the underlying portion is locally provided overlapping the opening portion of the mask in plan view.

51. A light emitting device, comprising:
a semiconductor substrate comprising an underlying substrate comprising a main substrate and a base semiconductor part located above the underlying substrate; and
a compound semiconductor part located above the semiconductor substrate and comprising a first light emitting portion,
wherein the base semiconductor part comprises a connection region in contact with the underlying substrate and a non-connection region separated from the underlying substrate, and
the semiconductor substrate comprises a first hole passing through the main substrate in a thickness direction and overlapping the first light emitting portion below the first light emitting portion.

52. The light emitting device according to claim 51, wherein the first light emitting portion overlaps the non-connection region above the non-connection region.

53. A light emitting device, comprising:
a semiconductor substrate comprising an underlying substrate that comprises a main substrate and a base semiconductor part located above the underlying substrate; and
a compound semiconductor part located above the semiconductor substrate and comprising a first light emitting portion,
wherein the base semiconductor part comprises a first portion and a second portion having a density of a dislocation extending in a thickness direction lower than the first portion, and
the semiconductor substrate comprises a first hole passing through the main substrate in a thickness direction and overlapping the first light emitting portion below the first light emitting portion.

54. The light emitting device according to claim 53, wherein the first light emitting portion overlaps the second portion above the second portion.

55. The light emitting device according to claim 51 or 53, further comprising
a hollow portion in contact with a lower surface of the base semiconductor part.

56. The light emitting device according to claim 55, wherein the hollow portion is in contact with the underlying substrate.

57. A display device, comprising:
a light emitting device described in any one of claims 1 to 56; and
a drive substrate on which the light emitting device is mounted.

58. An electronic device, comprising a light emitting device described in any one of claims 1 to 56.

59. A method for manufacturing a light emitting device described in any one of claims 1, 51, and 53, the method comprising:
forming the base semiconductor part by using an ELO method using a mask for selective growth; and
forming the first hole by etching the main substrate from a back surface thereof.

60. The method for manufacturing the light emitting device according to claim 59, further comprising
holding the semiconductor substrate and the compound semiconductor part on a drive substrate before forming the first hole.

61. The method for manufacturing the light emitting device according to claim 59 or 60, further comprising
reducing a thickness of the main substrate before forming the first hole.

62. A manufacturing apparatus for a light emitting device described in any one of claims 1, 51, and 53, the manufacturing apparatus performing:
forming the base semiconductor part by using an ELO method using a mask for selective growth; and
forming the first hole by etching the main substrate from a back surface thereof.
